(19) Europäisches Patentamt / European Patent Office / Office européen des brevets

(11) **EP 2 311 183 B1**

(12) **FASCICULE DE BREVET EUROPEEN**

(45) Date de publication et mention de la délivrance du brevet:
**29.04.2015 Bulletin 2015/18**

(21) Numéro de dépôt: **09784319.7**

(22) Date de dépôt: **29.07.2009**

(51) Int Cl.:
***H03D 3/00*** *(2006.01)*

(86) Numéro de dépôt international:
**PCT/FR2009/000949**

(87) Numéro de publication internationale:
**WO 2010/015739 (11.02.2010 Gazette 2010/06)**

(54) **CIRCUIT DE DÉMODULATION**

DEMODULATORSCHALTUNG

DEMODULATION CIRCUIT

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **05.08.2008 FR 0804460**

(43) Date de publication de la demande:
**20.04.2011 Bulletin 2011/16**

(73) Titulaire: **Groupe des Ecoles de Télécommunications - Ecole Nationale Supérieure des Télécommunications 75013 Paris (FR)**

(72) Inventeurs:
• **HUYART, Bernard**
  **F-77185 Lognes (FR)**
• **MABROUK, Kaïs**
  **F-77130 Montereau Fault-Yonne (FR)**

(74) Mandataire: **Hirsch & Associés
137, rue de l'Université
75007 Paris (FR)**

(56) Documents cités:
US-A- 5 095 536        US-A1- 2006 063 504
US-A1- 2006 141 970    US-B1- 6 335 952

• H. PARK ET AL.: "Unified DC Offset Cancellation and i/Q Regeneration with Carrier Phase Recovery in five port junction based Direct receivers" PROCEEDINGS OF THE 37TH EUROPEAN MICROWAVE CONFERENCE, 1 octobre 2007 (2007-10-01), pages 803-806, XP031191922

**Description**

La présente invention concerne un dispositif de conversion permettant de convertir un jeu de trois composantes mutuellement déphasées, d'un signal modulé reçu, en deux composantes de modulation orthogonales correspondant à la modulation du signal émis.

La démodulation, en réception d'un signal modulé, peut utiliser plusieurs principes.

Par exemple, le démodulateur comprend un corrélateur à cinq accès, précisément deux entrées et trois sorties. Les entrées reçoivent respectivement le signal à démoduler et le signal d'un oscillateur local calé sur sensiblement la fréquence porteuse du signal reçu. L'un de ces deux signaux est "divisé", sur trois voies en parallèle, en trois signaux mutuellement déphasés d'environ 120 degrés pour ainsi constituer trois paires de signaux. Les signaux de chaque paire sont ensuite additionnés et le signal somme est appliqué à un détecteur quadratique particulier, suivi d'un filtre passe-bas qui ne conserve que la bande de base. On peut donc considérer que les deux signaux d'entrée définissent, par leurs trois composantes déphasées, une grille ou matrice 3 x 3 dont on utilise une diagonale, c'est-à-dire les points d'intersection de même rang, c'est-à-dire homologues quant au déphasage.

Dans un autre cas, l'architecture du démodulateur est dite "triphasée", les trois additionneurs ci-dessus étant remplacés par trois multiplieurs, directement suivis des filtres passe-bas.

De tels modulateurs nécessitent d'effectuer une procédure de calibrage, qui, classiquement, est effectuée par un traitement numérique ou par des circuits analogiques. Ce calibrage peut s'effectuer en utilisant un réflectomètre après branchements successifs de trois charges prédéterminées, par exemple un court-circuit, un circuit ouvert et 50 ohms. Il faut toutefois une intervention manuelle.

Le calibrage peut aussi utiliser des méthodes automatique telles que le calibrage aveugle, les procédures d'ortho-normalisation et d'égalisation ou encore la méthode double ton.

La caractérisation aveugle, proposée par Yi Liu, Calibrating an industrial microwave six-port instrument using the artificial neural network technique, IEEE Transactions on Instrumentation and Measurements, 45(2):651-655, 1996, consiste à utiliser un réseau de neurones établi d'après des séquences d'apprentissage. Toutefois, le temps nécessaire d'apprentissage peut être relativement long, c'est-à-dire prohibitif par rapport au retard acceptable d'adaptation dans un réseau de télécommunication pour mobiles, pour lequel les conditions de propagation peuvent varier très rapidement.

Pour les procédures d'ortho-normalisation et d'égalisation, le calibrage est effectué en prenant en compte la technique de mélange des signaux utilisée dans les démodulateurs à cinq accès. Par exemple, si l'on utilise des circuits non linéaires, usuellement appelés détecteurs quadratiques de puissance, pour mélanger les deux signaux d'entrée, il faut ensuite éliminer les tensions parasites correspondant aux produits d'intermodulation, en particulier d'ordre deux, IMD2. Une telle procédure est exposée par Xinping Huang, Dan Hindson, Michel de Léséleuc, et Mario Caron dans l'article intitulé 1/q-channel regeneration in 5-port junction based direct receivers, paru en février 1999 dans IEEE MTT-S International Topical Symposium on technologies for wireless applications, pages 169-173. Il y est enseigné de mesurer les tensions de sortie des détecteurs à chaque temps symbole puis il est constitué une matrice de covariance des tensions afin de calculer ses valeurs propres. Les vecteurs propres définissent les constantes de calibrage.

La technique double ton prévoit que les deux signaux d'entrée soient à des fréquences légèrement décalées. Elle permet certes une réduction du nombre de manipulations, mais pas leur disparition totale, et elle ne permet pas de corriger les dérives thermiques des composants.

Toutes ces techniques traitent les signaux après numérisation, car le mélange des deux signaux d'entrée s'effectue au moyen de circuits dits quadratiques. Les tensions parasites intrinsèquement induites par ceux-ci réduisent considérablement la dynamique du récepteur.

Un autre problème qui se pose est de réduire au maximum le décalage de niveau continu (DC-offset). Ainsi, R. Sun et Coll. Présente, dans le brevet US 2006 038534 "DC offset cancellation circuit for receiver", QUALCOMM Inc., du 5 Avril 2007, un commutateur pour temporairement déconnecter le récepteur de l'antenne afin de mémoriser les tensions de décalage de niveau continu dues aux fuites de l'oscillateur local. Toutefois, un tel circuit constitue un circuit supplémentaire, dédié à ce problème spécifique, c'est-à-dire représente un accroissement du volume de matériel et ne traite que ces fuites.

L'élimination des composantes d'intermodulation d'ordre 2 représente aussi un autre problème. Ainsi, la publication de la demande de brevet WO 2008/021815 A1, enseigne un circuit de détection d'intermodulation par un calcul numérique de corrélation, et conversion en un signal analogique qui est soustrait au signal d'entrée. Toutefois, cette technique nécessite des convertisseurs Numérique-Analogique, CNA, et un dispositif de calcul de distorsion. L'article de Mike Faulkner, "DC Offset and IM2 Removal in Direct Conversion Receivers" IEE Electronics Letters, vol. 149, n°3, pages 179-184, juin 2002, propose un montage de réduction de l'intermodulation et du décalage de niveau continu. Par mesure du carré de la puissance, il est engendré, de façon analogique, une copie du signal parasite de distorsion, pour ensuite la soustraire au signal utile. Toutefois, cette technique nécessite de prévoir, sur chaque voie de sortie, un détecteur de puissance, un filtre et un amplificateur à gain variable, ce qui représente un accroissement notable du volume de matériel.

L'article par H. PARK ET AL.: "Unified DC Offset Cancellation and i/Q Regeneration with Carrier Phase Recovery in five port junction based Direct receivers", Proceedings of the 37th European Microwave Conference, 1 octobre 2007, pages 803-806, présente un circuit de démodulation à cinq portes, en particulier une méthode utilisant un signal continu en entrée pour calibrer le système, afin de déterminer des coefficients de pondération entre les trois phase du signal d'entrée. La démodulation est réalisée après la numérisation de ces trois phases du signal d'entrée.

La présente invention vise à proposer un circuit de fourniture des deux composantes en quadrature, I et Q, d'un signal modulé reçu, à partir de trois composantes mutuellement déphasées du signal reçu, ce circuit permettant de traiter au moins l'un des problèmes ci-dessus et ceci avec une grande économie de circuits.

A cet effet, l'invention concerne tout d'abord un circuit de démodulation de trois composantes mutuellement déphasées d'un signal en bande de base, afin de fournir deux composantes de démodulation en quadrature, caractérisé par le fait qu'il comporte :

- trois entrées de circuit, prévues pour recevoir respectivement les dites trois composantes,
- des premier et second circuits additionneurs, et
- un banc de circuits de pondération reliés, en entrée, aux trois entrées de circuit et reliés, en sortie, à des entrées des premier et second circuits additionneurs pour transmettre à chaque entrée d'additionneur, avec une pondération déterminée, l'une particulière des dites trois composantes, les pondérations étant choisies pour que les premier et second circuits additionneurs fournissent les deux dites composantes de démodulation en quadrature.

Chacun des premier et second circuits additionneurs reçoit ainsi plusieurs signaux d'entrée avec une pondération qui assure un bon équilibrage du signal vis-à-vis de plusieurs paramètres.

Une structure selon l'invention permet, grâce à l'équilibrage obtenu par la pondération, d'effectuer une annulation du décalage de niveau continu (DC-offset), c'est-à-dire que les trois décalages de niveau continu des trois signaux d'entrée se neutralisent mutuellement par composition vectorielle. Le résidu de décalage de niveau continu en sortie 1 et Q représente ainsi le niveau classique présent en entrée, mais divisé par un facteur bien supérieur à 1. Il s'en suit que la dynamique de mesure peut être accrue de ce même facteur puisque la saturation de la dynamique est "retardée" d'autant.

En outre, cet équilibrage permet de compenser des rotations de phase parasites dans la bande de fréquences utilisée, c'est-à-dire que le couplage croisé des entrées vers les deux circuits additionneurs permet d'asservir mutuellement les deux signaux I et Q de façon à les maintenir déphasés à l'intérieur d'une bande de fluctuation de phase relativement étroite autour des 90 degrés voulus, et ceci sur une bande de fréquences relativement large.

Le couplage croisé ci-dessus permet aussi d'assurer une bonne réjection par neutrodynage des signaux parasites entre canaux adjacents ou proches, par exemple les signaux d'intermodulation d'ordre 2, qui sont les plus gênants.

Dans une forme de réalisation, au moins l'un des premier et second circuits additionneurs est relié en entrée à trois des circuits de pondération.

En particulier, les premier et second circuits additionneurs peuvent être reliés en entrée à trois des circuits de pondération.

Dans une forme de réalisation très générale, le banc comporte six circuits de pondération.

Les circuits de pondération peuvent présenter chacun un facteur de pondération qui est prédéterminé.

Il s'agit là d'une caractéristique intéressante, qui montre qu'il n'y a pas nécessité d'effectuer le moindre processus d'adaptation en cours de fonctionnement. Il n'y a donc pas nécessité de circuits de réglage de pondération. On comprendra toutefois qu'il est parfaitement envisageable que les pondérations soient réglées par des points mémoires programmables, qui permettront ainsi d'utiliser un même type de circuit convertisseur selon l'invention dans divers démodulateurs traitant chacun des signaux dans une plage de fréquences qui leur est propre et qui peut nécessiter de choisir un jeu de paramètres de pondération optimisés pour l'application particulière.

Dans une forme de réalisation intéressante, le premier circuit additionneur comporte un premier amplificateur comportant des première et seconde entrées, respectivement à inversion et directe, respectivement reliées à deux dites entrées de circuit par des premier et cinquième circuits de pondération.

Cette forme de réalisation est ainsi particulièrement intégrée puisqu'un amplificateur, par exemple opérationnel, est bien agencé pour effectuer une opération de somme ou différence de signaux, avec toute amplification voulue, c'est-à-dire une dite pondération.

L'une des dites entrées du premier amplificateur peut en outre être reliée à une deuxième des dites entrées de circuit par un troisième circuit de pondération.

Un même amplificateur, par exemple opérationnel, peut ainsi effectuer la composition de trois signaux, avec la pondération voulue.

Le second circuit additionneur peut comporter un second amplificateur, par exemple opérationnel, dont une entrée, d'addition, est reliée à deux des entrées de circuit à travers des deuxième et sixième circuits de pondération, et un troisième amplificateur, par exemple opérationnel, présente une entrée, d'addition, reliée à la deuxième entrée de circuit à travers un quatrième circuit de pondération et en outre reliée à une sortie du deuxième amplificateur opérationnel à travers un septième circuit de pondération.

Le quatrième circuit de pondération peut présenter un coefficient de pondération de valeur sensiblement double de celle d'un coefficient de pondération du septième circuit de pondération.

L'invention concerne aussi un démodulateur présentant un étage de sortie comportant un circuit selon l'invention.

L'invention concerne enfin un procédé de démodulation de trois composantes mutuellement déphasées d'un signal en bande de base, afin de fournir deux composantes de démodulation en quadrature, caractérisé par le fait que :

- recevant les trois composantes mutuellement déphasées, on effectue une pondération de celles-ci, et
- on effectue des première et seconde additions de signaux ainsi pondérés, pour respectivement fournir les deux dites composantes de démodulation en quadrature.

L'invention sera mieux comprise à l'aide de la description suivante d'une forme de réalisation d'un circuit de démodulation et de traitement d'élimination de composantes parasites selon l'invention ainsi que d'un démodulateur comportant un tel circuit, et de la description d'un mode de mise en oeuvre d'un procédé correspondant, en référence au dessin annexé, sur lequel :

- la figure 1 est un diagramme schématique illustrant le cadre d'utilisation d'un circuit selon l'invention, dans un démodulateur de type à cinq accès ou bien de type triphasé,
- la figure 2 représente un démodulateur classique à corrélateur à cinq accès,
- la figure 3 représente un démodulateur triphasé classique,
- la figure 4 est un diagramme par blocs fonctionnels illustrant le circuit de l'invention,
- la figure 5 est un schéma détaillé d'un montage de circuits analogiques constituant un circuit selon l'invention,
- la figure 6 est formée des figures 6A, 6B et 6C, les figures 6A et 6B représentant un diagramme vectoriel de composition de signaux du circuit de la figure 5 pour obtenir la composante respectivement la composante imaginaire Q et la composante réelle I, et la figure 6C est un diagramme vectoriel de composition de signaux du circuit de la figure 5 et de signaux de décalage de niveau continu,
- la figure 7 représente trois tensions d'entrée du circuit de la figure 5 et les tensions de sortie représentant les deux composantes 1 et Q,
- les figures 8, 9 et 10 représentent un spectre respectif de puissance des trois tensions d'entrée de la figure 7,
- les figures 11 et 12 représentent un spectre respectif de puissance des deux composantes de sortie I et Q du circuit de la figure 5,
- la figure 13 représente l'évolution du niveau de décalage en continu des trois entrées et des deux sorties du circuit de la figure 5, en fonction d'une puissance d'oscillateur local,
- la figure 14 représente l'évolution du niveau de décalage en continu des trois entrées et des deux sorties du circuit de la figure 5, en fonction d'une fréquence d'oscillateur local,
- la figure 15 représente un produit en bande de base d'intermodulation d'ordre 2 due à des mélangeurs en amont du circuit de la figure 5, en fonction de la puissance d'un canal adjacent bi-ton,
- la figure 16 représente le déphasage entre les composantes de sortie I et Q pour une plage de fréquence allant de 1,6 à 2,8 GHz,
- la figure 17 représente une constellation QPSK démodulée à partir des sorties du circuit de la figure 5, et
- la figure 18 représente le résultat de mesures EVM (amplitude de vecteur d'erreur) effectuées sur la constellation de la figure 17.

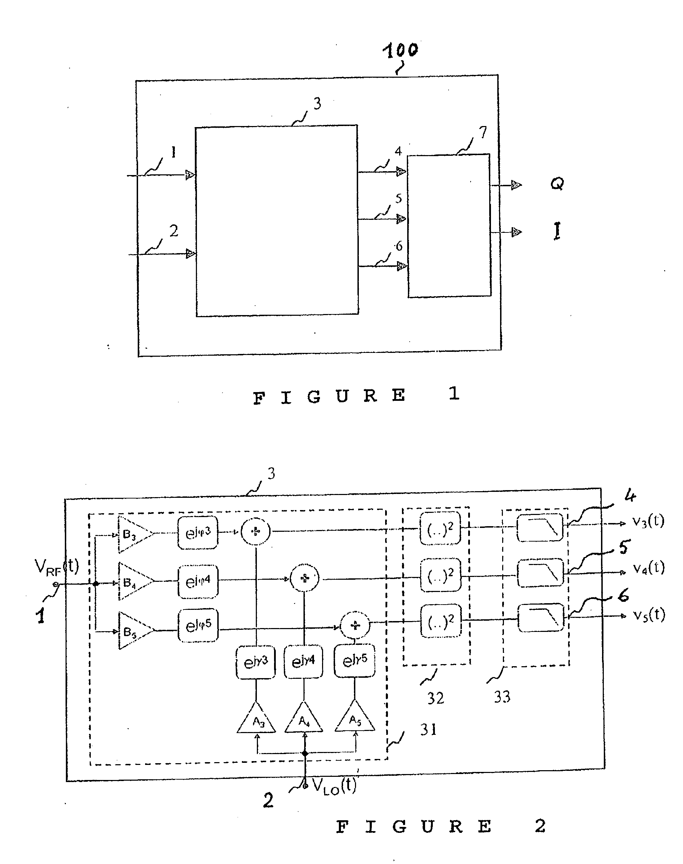

La figure 1 représente un démodulateur 100 constitué de deux blocs fonctionnels en série, à savoir un étage mélangeur 3, suivi d'un circuit convertisseur 7, selon l'invention, fournissant les deux composantes mutuellement orthogonales I et Q du signal modulé, à partir de trois composantes d'un signal modulé reçu, déphasées et traitées dans l'étage mélangeur 3.

L'étage mélangeur 3 mélange un signal modulé, ici à haute fréquence dans la gamme des gigaHertz, signal dit RF, appliqué à une première entrée de circuit 1, avec un signal d'oscillateur local appliqué à une seconde entrée de circuit 2. L'étage mélangeur 3 "divise" le signal RF en trois signaux sur un premier ensemble de trois voies respectives. Le signal de l'oscillateur local de la seconde entrée de circuit 2 est divisé en trois voies, la première voie étant déphasée de 120 degrés dans un sens par rapport à la seconde voie et la troisième voie étant déphasée de 120 degrés en sens opposé. Le signal de l'oscillateur local est ainsi transformé en une étoile régulière.

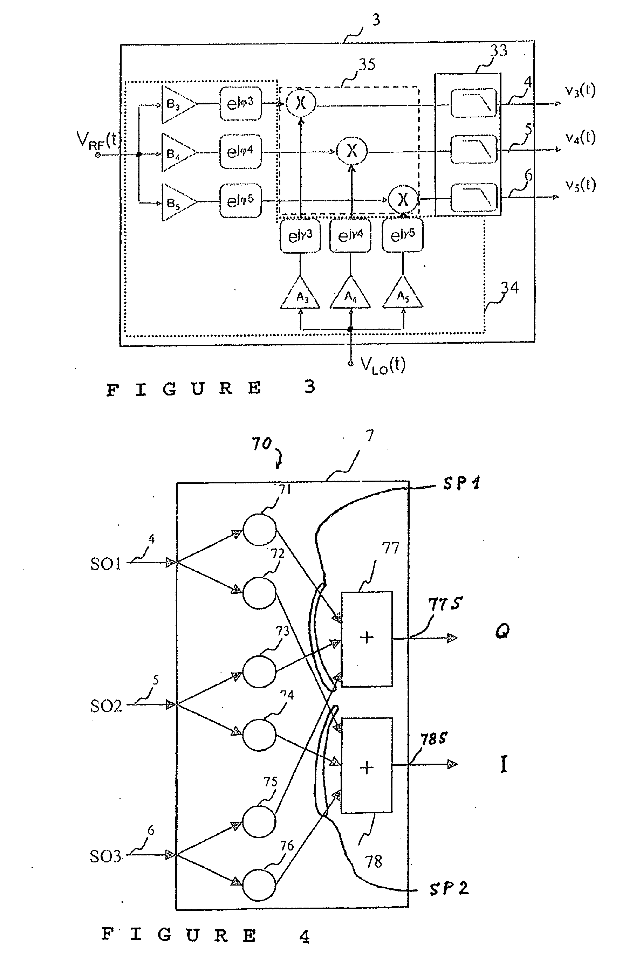

Il est ainsi défini une sorte de grille 3 x 3 et les points d'intersection des trois paires de signaux homologues, c'est-à-dire de même numéro de voie, comportent un élément mélangeur. Dans le cas de la figure 2, qui représente un étage mélangeur 3 de type corrélateur, chaque mélange s'effectue par un élément additionneur, dans le bloc référencé 31. Un détecteur quadratique aval complète l'opération de mélange. Dans le cas de la figure 3, l'étage mélangeur 3 comporte par contre un élément multiplieur, dans le bloc référencé 35.

En entrée du bloc 31 sur la figure 2, et dans un étage de sortie d'un bloc frontal déphaseur 34 de la figure 3, les termes en Ai et Bi (i = 3, 4, 5) représentent un gain, ou une atténuation, et les termes en $e^{j\varphi i}$ représentent des rotations de phase, qui sont ici toutes égales, c'est-à-dire sans déphasage mutuel entre les trois voies.

Une batterie de trois filtres passe-bas 33 filtre les trois signaux RF transposés en bande de base et transmis à trois liaisons respectives 4, 5, 6 en sortie du circuit démodulateur 3, selon trois signaux vi(t). Dans le présent exposé, les références 4, 5, 6 désignent tout aussi bien les liaisons ci-dessus que leur extrémité aval, c'est-à-dire des première, deuxième et troisième entrées de circuit du circuit convertisseur 7. Sur la figure 2, un banc de détecteurs quadratiques 32 est interposé entre les sorties du circuit de déphasage et d'addition 31 et le banc de filtres 33, du fait que le mélange est effectué par des éléments additionneurs.

En référence à la figure 4, le circuit convertisseur 7 comporte ainsi en entrée les arrivées des trois liaisons 4, 5, 6, ou entrées de circuit, transmettant des signaux respectifs SO1, SO2, SO3 (alias v3(t), v4(t), v5(t) évoqués ci-dessus), et il comporte deux sorties 77S et 78S pour les composantes respectives Q et I. Le circuit convertisseur 7 comporte un banc 70 de circuits de pondération, relié aux trois liaisons ou entrées de circuit 4, 5, 6 prévues pour recevoir les trois composantes mutuellement déphasées SO1, SO2, SO3 et fournir en réponse deux sous-ensembles de signaux pondérés SP1, SP2 à respectivement des premier et second circuits additionneurs 77 et 78, avec signe, fournissant respectivement les deux composantes de démodulation en quadrature Q, I sur les sorties respectives 77S et 78S. Il s'agit donc d'une pondération et d'un brassage des trois composantes SO1, SO2, S03.

Le banc de circuits de pondération 70 comporte ici six éléments de pondération, regroupés en des première, deuxième et troisième paires d'éléments pondérateurs 71-72, 73-74 et 75-76. La première paire d'éléments pondérateurs 71-72 sert à effectuer un brassage pondéré du premier signal SO1 vers les premier et le second circuits additionneurs 77, 78. Les premier et deuxième éléments pondérateurs 71-72 constituant la première paire sont ainsi chacun reliés en entrée à la première entrée de circuit 4, l'élément pondérateur 71 étant relié à une première entrée du premier circuit additionneur 77 et l'élément pondérateur 72 étant relié en sortie à une première entrée du second circuit additionneur 78.

Selon le même principe, les troisième et quatrième éléments pondérateurs 73-74 constituant la seconde paire sont chacun reliés en entrée à la deuxième entrée de circuit 5, le troisième élément pondérateur 73 étant relié en sortie à une deuxième entrée du premier circuit additionneur 77 et le quatrième élément pondérateur 74 étant relié en sortie à une deuxième entrée du second circuit additionneur 78.

Toujours selon le même principe, les cinquième et sixième éléments pondérateurs 75-76 constituant la troisième paire sont chacun reliés en entrée à la troisième entrée de circuit 6, le cinquième élément pondérateur 75 étant relié à une troisième entrée du premier circuit additionneur 77 et le sixième élément pondérateur 76 étant relié en sortie à une troisième entrée du second circuit additionneur 78.

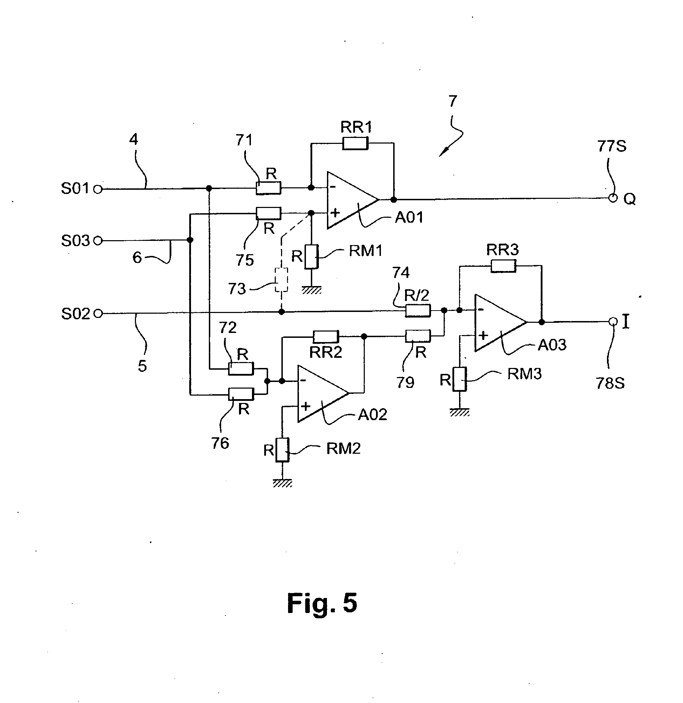

La figure 5 est un schéma d'une forme de réalisation d'un montage assurant les fonctions du circuit convertisseur 7. Dans un but de simplicité et de rapidité du traitement, le montage représenté est à base d'amplificateurs opérationnels et de résistances, c'est-à-dire que le traitement s'effectue sur des signaux analogiques. Les éléments pondérateurs 71, 73, 75 déterminent des gains mutuels respectifs -1, 0, +1, pour le premier sous-ensemble SP1 et les éléments pondérateurs 72, 74, 76 déterminent des gains mutuels respectifs +1, -2, +1 pour le second sous-ensemble SP2. L'ensemble de ces gains peut être multiplié par tout coefficient, positif ou négatif, supérieur ou inférieur à 1, puisque c'est l'amplitude relative entre ces gains qui importe. Comme il s'agit d'un montage triphasé, on peut aussi effectuer une permutation circulaire des trois gains ci-dessus de chacun des deux sous-ensembles SP1 et SP2, c'est-à-dire que par exemple le gain 0, au deuxième rang, peut aussi occuper le premier ou le troisième rang, et, de même, par exemple le gain -2, au deuxième rang, peut aussi venir occuper le premier ou le troisième rang. Compte tenu de l'inversion possible du signe du gain, le schéma la figure 5 permet six jeux de chacun six gains.

Le montage de la figure 5 comporte un premier amplificateur opérationnel AO1 fournissant le signal de composante imaginaire Q à partir des signaux SO1 et S03. Pour ce faire, l'entrée classique à inversion d'un tel amplificateur opérationnel AO1 est associée au point milieu d'un premier dipôle de rétroaction 71, RR1 formant pont diviseur, ici purement résistif.

Ainsi, les deux extrémités du premier pont diviseur de rétroaction 71, RR1 sont respectivement reliées à la première entrée de circuit 4 et à la sortie de l'amplificateur opérationnel AO1, le point milieu étant donc relié à l'entrée d'inversion du premier amplificateur opérationnel AO1. La résistance parallèle RR1 est donc branchée en rétroaction pour stabiliser le montage et la valeur de la résistance série 71 est choisie à un pourcentage donné de la valeur de la résistance RR1, pour ainsi fixer le gain. De ce fait, et en toute rigueur, l'élément pondérateur 71 de la figure 4 est en fait constitué par le premier dipôle 71, RR1. Pour la simplicité du présent exposé, la résistance de rétroaction RR1 est supposée être préalablement fixée et c'est donc alors la valeur de la résistance série 71 qui fixe le coefficient de pondération.

Les deux extrémités d'un pont diviseur 75, RM1, de polarisation en entrée, sont respectivement reliées à la troisième entrée de circuit 6 et à la masse, le point milieu étant donc relié à l'entrée directe, c'est-à-dire sans inversion, du premier amplificateur opérationnel AO1. La résistance en dérivation RM1 assure ainsi un rappel de polarisation vers une référence de tension fixe et sa valeur sert de référence pour choisir la valeur de la résistance série 75 afin de fixer la pondération voulue.

On notera que, dans cet exemple, l'élément pondérateur 73 n'est qu'évoqué par des pointillés, car le facteur de pondération est égal à zéro. Sinon, il s'agirait d'une résistance reliant la deuxième entrée de circuit 5 au point milieu du pont diviseur 75, RM1, c'est-à-dire l'entrée directe.

Le signal de composante réelle I de l'enveloppe du signal à démoduler est fourni par un montage à base de deuxième et troisième amplificateurs opérationnels AO2 et AO3 en série. Tous les amplificateurs ci-dessus sont commercialisés sous la référence LM6142 par la société National Semiconductor. Le deuxième amplificateur opérationnel AO2 est associé à un deuxième dipôle de rétroaction 72, RR2 selon le schéma exposé pour le premier dipôle 71, RR1, dont l'explication ne va donc pas être répétée. Le premier signal SO1 est ainsi appliqué de façon pondérée sur l'entrée à inversion du deuxième amplificateur opérationnel A02. Toutefois, le second dipôle 72, RR2 est intégré dans une structure en Y, c'est-à-dire que son point milieu est en outre relié à la troisième entrée de circuit 6, pour le troisième signal SO3 à travers une résistance 76. L'entrée directe du deuxième amplificateur opérationnel AO2 est rappelée à la masse par une résistance RM2. La structure en Y constitue ainsi un additionneur pour les premier et troisième signaux SO1 et S03.

Le troisième amplificateur opérationnel AO3 est de même polarisé, au niveau d'une entrée à inversion, par un troisième dipôle 74, RR3 relié à la deuxième entrée de circuit 5. Là encore, le troisième dipôle 74, RR3 est intégré dans une structure en Y, avec une résistance 79 qui relie la sortie du deuxième amplificateur opérationnel AO2 au point milieu du troisième dipôle 74, RR3. La structure en Y constitue ainsi un additionneur pour, d'une part, le signal de somme partielle pondérée des premier et troisième signaux SO1 et SO3 et, d'autre part, le deuxième signal S02. L'entrée directe du troisième amplificateur opérationnel AO3 est rappelée à la masse par une résistance RM3.

Dans cet exemple, les résistances de rétroaction RR1, RR2, RR3 sont toutes de même valeur, par exemple une valeur dans la plage allant de 1 à 10 kΩ. De même ici, les résistances série de pondération 71, 72, 75, 76 présentent une même valeur dans cette plage. Précisément, dans cet exemple particulier, toutes les diverses résistances ci-dessus présentent une même valeur, hormis la résistance 74 qui présente une valeur moitié. De la sorte, le gain des premier et deuxième amplificateurs opérationnels AO1 et AO2 est à valeur absolue unitaire, c'est-à-dire pour les premier et troisième signaux SO1 et S03. La valeur absolue du gain est toutefois de 2 pour le deuxième signal S02. Les résistances 71 à 76 définissent ainsi, dans cet ordre, un jeu de gains valant : -1, +1, 0, -2, +1, +1.

On notera toutefois que rien ne s'oppose, au niveau du principe, à ce que les fonctions de pondération et d'addition soient effectuées après traversée de trois convertisseurs analogique - numérique.

De même, l'utilisation de composants actifs, sous forme d'amplificateurs opérationnels, est optionnelle. En effet, dans la mesure où les trois signaux d'entrée SO1, SO2, SO3 sont fournis par des circuits à impédance de sortie suffisamment faible, il est possible d'effectuer l'addition pondérée des trois signaux en alimentant une résistance commune, constituant un tronc constituant le circuit additionneur 77 ou 78, par trois résistances (71, 72, 73 ou 74, 75, 76) formant des branches du Y convergeant vers une même extrémité de celle-ci, son autre extrémité étant polarisée à une tension de référence, par exemple la masse. Les deux structures en Y précédentes, en cascade, sont ainsi intégrées en une structure unique. La tension aux bornes de cette résistance commune peut éventuellement servir à commander la base ou la grille d'un transistor aval qui va amplifier le signal de composante I ou Q à un niveau mieux exploitable par des circuits aval d'exploitation de ces signaux. En outre, le transistor ci-dessus, appartenant éventuellement à un amplificateur opérationnel, va restituer le signal sous une impédance réduite, quelques ohms ou dizaines d'ohms, par rapport à l'ordre de grandeur des résistances de pondération 71-76, qui sont de l'ordre de grandeur du kiloohm. La sortie du transistor abaisseur d'impédance constitue donc une source de tension, c'est-à-dire une tension quasiment insensible à la charge présentée par l'entrée du circuit aval d'exploitation, ceci dans une plage de courants prévue pour cette sortie.

Comme il s'agit de pondérer chaque signal d'entrée, on conçoit que les ponts diviseurs résistifs ci-dessus ne sont qu'un cas particulier de réalisation de cette fonction, cette forme de réalisation présentant toutefois une grande simplicité puisque les résistances peuvent être réalisées facilement, par exemple par des composants discrets sous forme de pavés résistifs soudés sur un circuit de connexions, ou sous forme plus intégrée, c'est-à-dire des pistes d'encre résistive, par exemple en couche épaisse, ou sous forme de volume résistif dans une puce de semi-conducteur constituant le dispositif selon l'invention. Dans d'autres formes de réalisation, le pont diviseur peut être à base de condensateurs ou d'éléments selfiques. Il peut en outre être prévu un circuit correcteur de pondération dans une plage de fréquences à l'intérieur de la plage globale prévue, le circuit correcteur augmentant ou diminuant l'amplitude du signal considéré appliqué sur le circuit additionneur. D'une façon générale, la pondération ci-dessus peut aussi s'effectuer sans utiliser de pont diviseur, et par exemple en utilisant un amplificateur à gain commandé ou encore un circuit de traitement de signal, DSP. Cette dernière solution est toutefois plus lourde à mettre en oeuvre.

Par rapport à une solution n'utilisant que des composants passifs, on notera toutefois que la présence d'un amplificateur opérationnel, dont une entrée est reliée à l'extrémité de la résistance commune constituant le point de convergence des trois branches, fournit un découplage entre les branches, c'est-à-dire évite qu'une fraction de chacun des trois signaux SO1, SO2, SO3 ne soit réinjectée vers les deux autres entrées parmi les entrées de circuit 4, 5 ou 6. En effet, une entrée d'amplificateur opérationnel ne varie que très peu en tension et constitue ainsi une masse fictive qui assure le découplage entre les diverses branches affluentes. On peut donc tolérer que les impédances de sortie des circuits commandant les entrées de circuit 4, 5, 6 soient relativement élevées, c'est-à-dire dépassent quelques dizaines d'ohms.

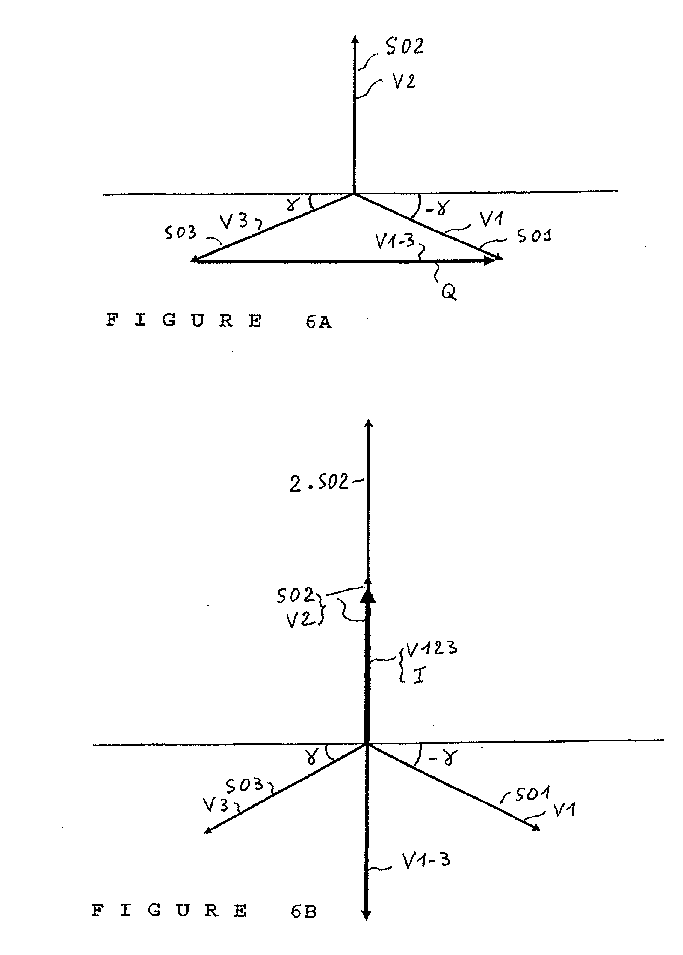

La figure 6A illustre la détermination d'un vecteur V1-3 représentant le signal de composante imaginaire Q. La figure 6A montre le diagramme vectoriel V1, V2, V3 des trois signaux SO1, SO3 et SO2, ce dernier étant représenté dirigé verticalement vers le haut. Le signal de composante imaginaire Q est donc constitué par le vecteur différence V1-3 entre les signaux SO1 et SO3 tous deux descendant à 30 degrés vers la droite ou vers la gauche, selon un angle γ d'environ 30 degrés sur l'horizontale. Le signal de composante imaginaire Q vaut donc √2 par rapport à l'amplitude des signaux d'entrée SO1, SO3 et est représenté par le vecteur V1-3 horizontal, donc perpendiculaire au vecteur V2 du deuxième signal S02. On comprendra que, dans l'exposé ci-dessous, c'est le vecteur V2 qui sert de référence d'orientation pour définir l'horizontale, qui lui est perpendiculaire, c'est-à-dire que l'exposé resterait valable, avec la transposition voulue, si l'ensemble des vecteurs V1, V2, V3 subissait globalement une certaine rotation.

L'horizontalité du vecteur V1-3 est donc due au fait que les deux vecteurs V1 et V3 présentent une même composante verticale, c'est-à-dire que leurs extrémités libres sont à une même hauteur. Cette condition est ici obtenue de par l'égalité des amplitudes des vecteurs V1 et V3 et leur même valeur absolue d'angle γ par rapport à l'horizontale ou à la verticale (vecteur V2). C'est donc le choix approprié du couple de valeurs des deux paramètres amplitude et angle qui permet d'établir l'horizontalité voulue, c'est-à-dire l'annulation de toute différence des composantes verticales des vecteurs V1 et V3. On conçoit toutefois que l'effet d'un choix d'angles de descente différents peut être compensé par un raccourcissement ou allongement de l'un des vecteurs V1, V3, pour ainsi rétablir l'horizontalité du vecteur VI-3. En d'autres termes, les deux extrémités libres des premier et troisième vecteurs V1 et V3 peuvent "glisser" sur une même horizontale.

La figure 6B illustre la détermination d'un vecteur V123 représentant le signal de composante réelle I. On voit que la somme des premier et troisième vecteurs V1 et V3 représentant les signaux SO1 et SO3, inclinés de façon symétrique par rapport à la verticale, fournit un vecteur vertical descendant V1-3 de valeur d'environ 2 x sin -30 degrés, c'est-à-dire une amplitude égale à celle des signaux individuels SO1 ou SO3. Compte tenu de l'inversion amenée par le deuxième amplificateur opérationnel AO2, le troisième amplificateur opérationnel AO3 effectue un calcul de différence selon la formule : 2 V2 - V1-3, les vecteurs V1-3 et V2 étant colinéaires et opposés et présentant sensiblement la même amplitude. Le vecteur résultat V123 est donc vertical et montant et d'amplitude unitaire, c'est-à-dire sensiblement égale à celle des signaux SO1, ou SO2 ou S03.

On notera que la verticalité du vecteur V123, c'est-à-dire l'annulation des composantes horizontales, tient au fait que les composantes horizontales opposées des vecteurs V1 et V3 sont de même amplitude, du fait que les vecteurs V1 et V3 sont eux-mêmes de même amplitude et inclinés de même, au signe près, sur la verticale ou sur l'horizontale. On conçoit que, si l'un de ces deux paramètres, amplitude et inclinaison, varie par rapport aux conditions exposées pour cet exemple, l'autre paramètre permet de compenser l'effet de cette variation pour rétablir l'égalité des amplitudes des composantes horizontales des vecteurs respectifs V1 et V3.

On notera aussi que la correction de phase relative entre les deux composantes de sortie I et Q peut aussi, de façon duale, s'effectuer en induisant, sur la composante de sortie I ou Q non affectée par le déphasage parasite, un déphasage de correction égal au déphasage parasite. De la sorte, l'ensemble des deux composantes de sortie I et Q tourne en bloc et conserve donc le déphasage relatif voulu.

La schéma de la figure 5 représente une forme de réalisation simple et efficace pour obtenir les deux vecteurs de sortie VI-3 et V123 selon les amplitudes voulues et avec un déphasage proche des 90 degrés visés. On conçoit que la plage de variation autorisée autour de la condition de quadrature parfaite dépend de l'utilisation envisagée, et qu'en particulier cette plage peut être élargie si le débit de transmission des symboles ainsi transmis est réduit. On peut par exemple fixer une marge de ± 30 degrés. En pareil cas, on pourra tolérer une dispersion des gains individuels dans les jeux ci-dessus d'environ 70%.

Des essais de démodulation en utilisant le circuit convertisseur 7 comme étage de sortie d'un circuit mélangeur 3 ont montré que le circuit convertisseur 7 procurait un gain de qualité en ce qui concerne le décalage de niveau continu (DC-offset), la dynamique de mesure offerte, et l'intermodulation, en particulier d'ordre 2.

En ce qui concerne le décalage de niveau continu, des tensions de décalage de niveau continu mesurées aux sorties 4, 5, 6 d'un circuit mélangeur 3 à cinq accès s'élevaient à environ 100mV. Par contre, ces mêmes tensions appliquées au circuit convertisseur 7 donnent environ 4 mV sur le signal de composante réelle I et un peu plus de 0,1 mV sur le signal de composante quadratique Q, c'est-à-dire une réduction d'un facteur respectif d'environ 25 et un peu moins de 1000.

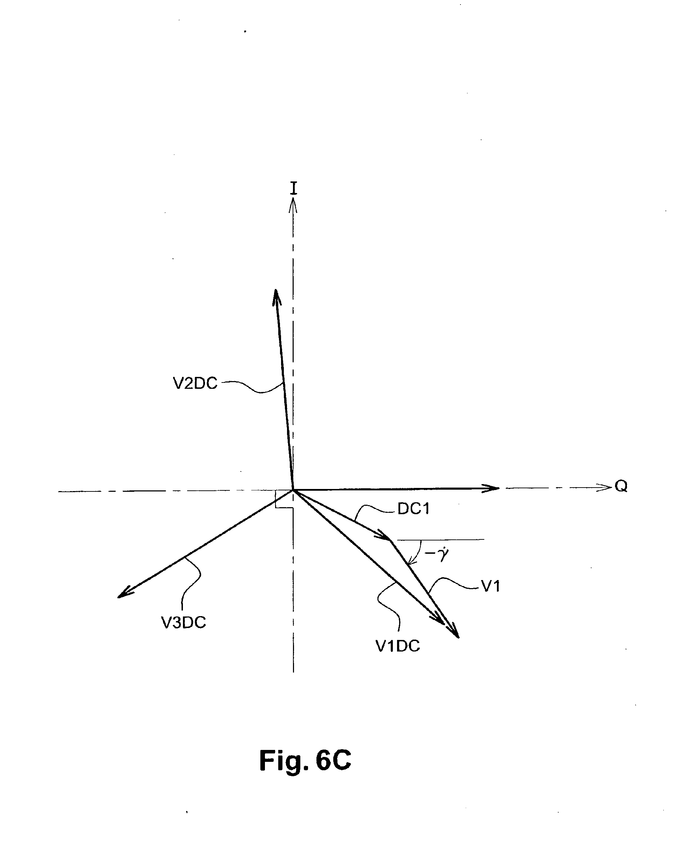

La figure 6C illustre le décalage de niveau continu, avec un premier vecteur de décalage DC1 qui s'ajoute, de façon sensiblement colinéaire, au premier vecteur V1 pour former un premier vecteur somme V1DC. De même, le vecteur V2 est affecté par un deuxième vecteur montant de décalage de niveau continu, sensiblement colinéaire, (non dessinés) d'où il résulte un deuxième vecteur somme V2DC. Le troisième vecteur V3 est de même affecté par un troisième vecteur de décalage de niveau continu sensiblement colinéaire avec le troisième vecteur V3, d'où il résulte un troisième vecteur somme V3DC. On conçoit donc que l'addition vectorielle de ces trois vecteurs de décalage aboutit à une annulation de ceux-ci.

En ce qui concerne la dynamique de mesure, la valeur crête des fluctuations parasites ci-dessus est ramenée à environ 10 mV, c'est-à-dire réduite d'un facteur 10. La dynamique de mesure est donc accrue d'autant.

En ce qui concerne l'intermodulation d'ordre 2, la plus gênante, due aux mélangeurs des circuits 3, le circuit convertisseur 7 apporte une amélioration par atténuation d'un facteur 100 environ.

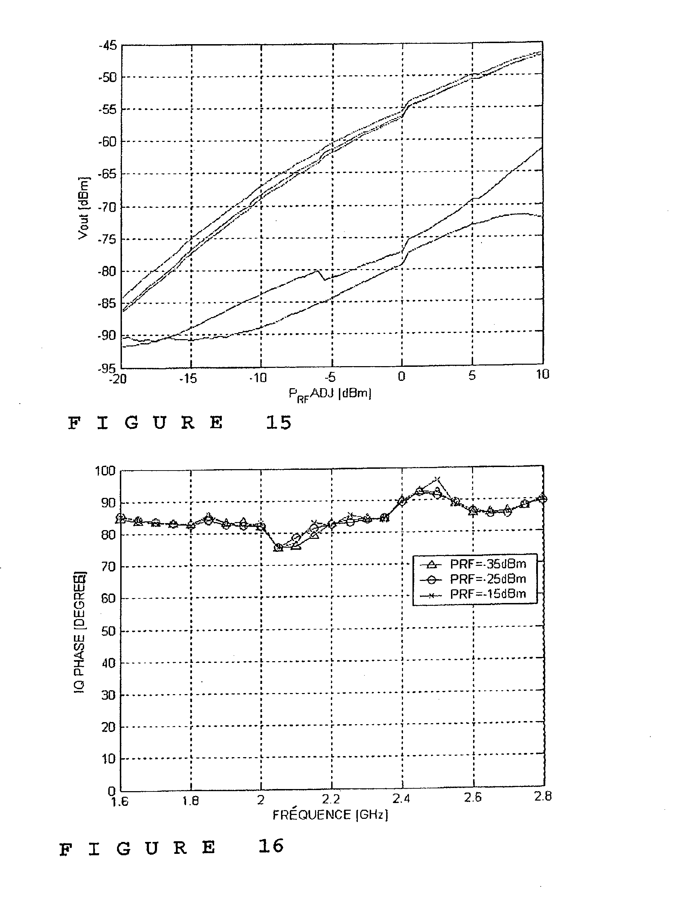

La figure 16 illustre la stabilité de l'orthogonalité des voies I et Q. En effet, le déphasage, dans une bande de fréquences allant de 1,6 à 2,8 GHz, reste dans une marge de -15 à +6 degrés autour des 90 degrés requis, la descente au-dessous de 80 degrés étant en outre limitée à une zone étroite de fréquences allant de 2 à un peu plus de 2,1 GHz.

Comme évoqué plus haut, on peut prévoir de compenser les crêtes de dérive à déphasage maximal, ici - 15 degrés, en prévoyant que certains des éléments pondérateurs 71-76 soient sensibles à la fréquence, c'est-à-dire que le facteur de pondération qu'ils fournissent soit quelque peu modulé en fonction de la fréquence. En effet, si l'on augmente le rapport de la composante imaginaire Q par rapport à la composante réelle I, ceci par augmentation du facteur de pondération des éléments pondérateurs 71 et 75 du premier sous-ensemble SP1 ou diminution du facteur de pondération des éléments pondérateurs 72, 74, 76 du second sous-ensemble SP2, par exemple en augmentant leur valeur d'impédance série, on favorise ainsi la composante imaginaire Q. La variation du facteur de pondération peut par exemple s'effectuer en intégrant un circuit bouchon L, C en série dans la branche, série 71 ou 75 ou de rétroaction RR1, de pont diviseur dont l'impédance doit croître dans une plage de fréquences. De façon duale, on peut aussi insérer un circuit L, C série pour en diminuer l'impédance dans une plage de fréquences.

Il peut aussi être prévu que cette sensibilité se traduise par une légère rotation de phase des signaux de l'un des deux sous-ensembles SP1 et SP2. Un élément capacitif ou selfique sera alors intégré, en série ou en parallèle, dans l'une des deux branches du circuit pondérateur 71-76 considéré pour ainsi introduire une fonction de filtre du premier ordre, passe-bas ou passe-haut. L'homme du métier connaît évidemment de tels filtres, de sorte qu'il est inutile de les décrire ici.

La rotation ci-dessus revient donc à prendre en compte, pour chaque sous-ensemble SP1 ou SP2, une fraction d'un ou plusieurs des signaux d'entrée SO1, SO2, SO3 fraction qui est déphasée par rapport au signal d'entrée SO1, SO2, SO3 considéré. On notera que la correction de phase s'effectue individuellement dans chaque élément pondérateur 71-76, c'est-à-dire que, bien que chaque signal d'entrée SO1, SO2, SO3 soit appliqué à une paire d'éléments pondérateurs 71-76, le déphasage de l'un des éléments pondérateurs ne se répercute pas sur l'autre. En d'autres termes, les réglages individuels de déphasage sont mutuellement indépendants.

D'une façon générale, le circuit convertisseur 7 peut donc constituer un étage de sortie d'un démodulateur comportant un étage d'entrée 3.

Le circuit convertisseur 7 correspond à un procédé de traitement du signal. Il s'agit donc d'un procédé de démodulation et de traitement d'élimination de composantes parasites présentes dans trois composantes mutuellement déphasées d'un signal en bande de base, afin de fournir deux composantes de démodulation en quadrature I, Q, dans lequel :

- recevant les trois composantes mutuellement déphasées, on effectue une pondération de celles-ci, et
- on effectue des première et seconde additions de respectivement deux sous-ensembles de signaux ainsi pondérés, pour respectivement fournir les deux dites composantes de démodulation en quadrature I, Q.

Sans vouloir être lié par celle-ci, il est fourni ci-après une explication visant à illustrer le modèle de calcul que représente le circuit convertisseur 7. Il faut toutefois noter qu'il s'agit là d'une explication qui, pour le cas où elle comporterait des imperfections, ne peut remettre en cause l'invention elle-même puisque celle-ci procure effectivement les résultats escomptés.

Les Annexes 1 et A et B fournissent un complément d'explications sous forme d'équations des signaux.

ANNEXE 1

En fixant à une valeur $f_c$ la fréquence porteuse du signal utile RF sur la première entrée de circuit 1 et la fréquence de l'oscillateur local sur la seconde entrée de circuit 2, leurs représentations passe-bande sont alors données par :

$$v_{RF}(t) = \Re\left[z(t)e^{j2\pi f_{RF}t}\right] \tag{1}$$

$$v_{LO}(t) = \Re\left[V_{LO}e^{j2\pi f_c t}\right] \tag{2}$$

où $V_{LO}$ est l'amplitude du signal de l'oscillateur local, $f_{RF}$ est la fréquence porteuse du signal modulé $V_{RF}$, $z(t) = a(t)e^{j\theta(t)}$ = $I(t) + j * Q(t)$ est son enveloppe complexe dans laquelle $a(t)$ et $\theta(t)$ sont respectivement l'amplitude et la phase de l'enveloppe en fonction du temps $t$. Dans le cas d'un démodulateur Low-IF, la fréquence $f_c$ est légèrement décalée de $f_{RF}$. Dans le cas d'un démodulateur Zéro-IF, on a $f_{RF} = f_c$. La suite des calculs s'applique au cas Zéro-IF mais pourrait être menée de façon identique pour le cas Low-IF.

La jonction à cinq accès 3 utilisée dans le démodulateur peut être réalisée soit par un corrélateur « *cinq-port* » (Figure 2) ou « *un triphasé* » (Figure 3). Dans les deux cas, les signaux aux entrées 1 et 2, respectivement représentés théoriquement par $v_{RF}(t)$ et $v_{LO}(t)$, sont chacun divisés en trois voies. Chacune des voies introduit un gain et un déphasage symbolisés par $Ai$, $Bi$ et $\gamma i$, $\varphi i$, qui sont respectivement les modules et les arguments des constantes complexes propres au circuit. Dans le cas du circuit « *cinq-port* », chacun des signaux provenant des trois voies de la seconde entrée de circuit 2 est additionné au signal RF $v_{RF}(t)$ de la première entrée de circuit 1 puis détecté par un détecteur quadratique. Dans le cas du circuit « *triphasé* », chacun des signaux provenant des trois voies de la seconde entrée de circuit 2 est multiplié par le signal RF $v_{RF}(t)$ de la première entrée de circuit 1. Finalement les trois signaux de sortie sont filtrés par les filtres passe-bas 33 pour fournir les trois tensions de sortie en bande de base.

On note par $h_{pb}(t)$ la réponse impulsionnelle des filtres passe-bas 33 et * est l'opérateur intégral de convolution.

En utilisant le modèle du circuit 3 illustré par la figure 2, on déduit la relation reliant les entrées 1 et 2 aux bornes 4, 5 et 6 (de sortie, constituant aussi les première, deuxième et troisième entrées de circuit pour le circuit 7) par :

$$v_i(t) = \left\{A_i V_{LO}\cos(2\pi f_c t + \gamma i) + B_i a(t)\cos(2\pi f_c t + \theta(t) + \varphi i)\right\}^2 * h_{pb}(t) \quad i = 3, 4, 5 \tag{3}$$

En utilisant le modèle du circuit 3 illustré par la figure 3 et en prenant compte le phénomène de distorsion d'ordre 2 (IMD2), on déduit la relation reliant les signaux entrées 1 et 2 à ceux des bornes 4, 5 et 6 par :

$$v_i(t) = \left\{A_i V_{LO}\cos(2\pi f_c t + \gamma i) \times B_i a(t)\cos(2\pi f_c t + \theta(t) + \varphi i) + IMD2\right\} * h_{pb}(t) \quad i = 3, 4, 5 \tag{3-bis}$$

Ces deux dernières relations sont équivalentes, sauf que, dans le cas du cinq-port, illustré par la figure 2, les termes en IMD2 sont plus élevés que ceux du triphasé qui est illustré par la figure 3.

On suppose que la réponse fréquentielle des filtres passe-bas 33 est telle que :

$$H_{pbi}(f) = \begin{cases} K_{bpi} & si \quad (-B_{pb} < f < B_{pb}) \\ 0 & ailleurs \end{cases} \tag{4}$$

où $2B_{pb}$ est la bande passante de $z(t)$ en Hz. Les tensions $v_i(t)$ n'auront que des composantes en bande de base comme le montrent les expressions suivantes :

$$v_3(t) = K_{pb3}\frac{A_3^2 V_{LO}^2}{2} + K_{pb3}\frac{B_3^2 a^2(t)}{2} + K_{pb3}A_3 B_3 V_{LO}a(t)\cos[\theta(t) - \phi_3] \tag{5}$$

$$v_4(t) = K_{pb4}\frac{A_4^2 V_{LO}^2}{2} + K_{pb4}\frac{B_4^2 a^2(t)}{2} + K_{pb4}A_4 B_4 V_{LO}a(t)\cos[\theta(t) - \phi_4] \tag{6}$$

$$v_5(t) = K_{pb5}\frac{A_5^2 V_{LO}^2}{2} + K_{pb5}\frac{B_5^2 a^2(t)}{2} + K_{pb5}A_5 B_5 V_{LO}a(t)\cos[\theta(t) - \phi_5] \tag{7}$$

avec

$$\phi_i = -(\varphi_i - \gamma_i) \tag{8}$$

Il est important de noter que, dans ces équations, toutes les opérations de mélange ou de détections quadratiques des signaux ainsi que les imperfections des circuits RF sont prises en compte.

Le terme $a^2(t)$, qui apparaît dans le signal en bande, est le carré de l'enveloppe du signal. Dans le cas du modèle à mélangeurs, ce terme pourra représenter également l'enveloppe du canal adjacent en prenant compte des non linéarités des mélangeurs. Si le signal attendu est à enveloppe constante, alors $a^2(t)=cte$ et donc il est compris dans les termes DC, sinon il peut s'écrire comme :

$$a^2(t) = Cte + a^2{}_{env}(t)$$

avec Cte : moyenne de $a^2(t)$(DC), et
$a^2{}_{env}(t)$ partie variable de $a^2(t)$ de moyenne nulle.

On note par :

$$R_i = \frac{1}{2} K_{pbi} B_i^2 \, , \ S_i = K_{pbi} A_i B_i V_{LO} \, , \ K_i = \frac{1}{2} K_{pbi} A_i^2 B_i^2 V_{LO}^2 \, , \ z_I(t) = a(t) cos\,\theta(t) ,$$

$$z_Q(t) = a(t) sin\,\theta(t) \ \text{et} \ n(t) = a^2(t) \tag{9}$$

Les équations (5), (6) et (7) s'écrivent alors :

$$v_3(t) = R_3 n(t) + S_3 \, cos\,\phi_3 z_I(t) + S_3 \, sin\,\phi_3 z_Q(t) + K_3 \tag{10}$$

$$v_4(t) = R_4 n(t) + S_4 \, cos\,\phi_4 z_I(t) + S_4 \, sin\,\phi_4 z_Q(t) + K_4 \tag{11}$$

$$v_5(t) = R_5 n(t) + S_5 \, cos\,\phi_5 z_I(t) + S_5 \, sin\,\phi_5 z_Q(t) + K_5 \tag{12}$$

Les signaux en bande de base désirés sont $z_I(t)$ et $z_Q(t)$. Il est possible, en utilisant des coefficients de pondération, de les déterminer à partir des équations (10), (11) et (12).

$$z_I(t) = \mu_I (r_I v_3(t) + s_I v_4(t) + t_I v_5(t)) \tag{13}$$

$$z_Q(t) = \mu_Q (r_Q v_3(t) + s_Q v_4(t) + t_Q v_5(t)) \tag{14}$$

Les constantes $\mu_I$, $r_I$, $s_I$, $t_I$, $\mu_Q$, $\mu_Q$, $s_Q$ et $r_Q$ sont les constantes de calibrage déterminées habituellement par plusieurs techniques connues.

$\mu_I$ et $\mu_Q$ sont des coefficients appliqués aux trois tensions, et il est possible de les estimer ultérieurement lors de l'opération d'égalisation effectuée généralement dans tous les démodulateurs.

Par un procédé numérique lors de l'égalisation, une matrice $M$ sera déterminée pour relier les termes de bande de base émis $z_I''(t)$ et $z''_Q(t)$ à ceux reçus $Z_I(t)$ et $z_Q(t)$.

$$\begin{bmatrix} z_I'' \\ z_Q'' \end{bmatrix} = M \times \begin{bmatrix} z_I \\ z_Q \end{bmatrix} \tag{15}$$

où M est une matrice 2x2, déterminée comme pour tous les démodulateurs IQ classiques en utilisant la séquence d'apprentissage, qui contient les données du canal ainsi que les termes $\mu_I \, \mu_Q$ qui ne sont pas pris en compte par le circuit analogique 3.

En conclusion, l'opération (13) et (14) de démodulation permettant de recouvrer les données I et Q, notée $z_I(t)$ et $z_Q(t)$, est faite par le circuit 7 par implémentation des coefficients de *pondération* $r_I$, $s_I$, $t_I$, $r_Q$, $s_Q$, $t_Q$ des éléments du banc 70. Les facteurs multiplicatifs $\mu_I$ et $\mu_Q$ sont inclus dans les coefficients d'égalisation lors de l'estimation du canal de propagation radio.

Analyse des deux composantes de sortie du circuit 7

Reprenant les équations brutes de sortie (10)-(12) déduites du modèle sans aucune approximation :

$$v_3(t) = R_3 n(t) + S_3 \cos\phi_3 z_I(t) + S_3 \sin\phi_3 z_Q(t) + K_3$$

$$v_4(t) = R_4 n(t) + S_4 \cos\phi_4 z_I(t) + S_4 \sin\phi_4 z_Q(t) + K_4$$

$$v_5(t) = R_5 n(t) + S_5 \cos\phi_5 z_I(t) + S_5 \sin\phi_5 z_Q(t) + K_5$$

Les expressions des tensions de sortie (en appliquant les coefficients équivalents de calibrage implémentés dans le circuit 7 [pour plus de détail voir annexe A]) sont :

$$z_I{}'(t) = R_I n(t) + [r_I S_3 \cos\phi_3 + s_I S_4 \cos\phi_4 + t_I S_5 \cos\phi_5] z_I(t) + [r_I S_3 \sin\phi_3 + s_I S_4 \sin\phi_4 + t_I S_5 \sin\phi_5] z_Q(t)$$
$$+ K_I \qquad\qquad (16)$$

$$z_Q{}'(t) = R_Q n(t) + [r_Q S_3 \cos\phi_3 + s_Q S_4 \cos\phi_4 + t_Q S_5 \cos\phi_5] z_I(t) + [r_Q S_3 \sin\phi_3 + s_Q S_4 \sin\phi_4 + t_Q S_5 \sin\phi_5] z_Q(t)$$
$$+ K_Q \qquad\qquad (17)$$

avec, en sortie 78S et 77S du circuit 7, les termes multiplicatifs des tensions parasites dus à l' IMD2 :

$$R_I = r_I R_3 + s_I R_4 + t_I R_5 \quad \text{et} \quad R_Q = r_Q R_3 + s_Q R_4 + t_Q R_5 \qquad\qquad (18)$$

et ceux dus aux décalages de niveau continu (DC-offset) :

$$K_I = r_I K_3 + s_I K_4 + t_I K_5 \quad \text{et} \quad K_Q = r_Q K_3 + s_Q K_4 + t_Q K_5 \qquad\qquad (19)$$

On démontre, en utilisant ces deux dernières équations et le développement fait en annexe B, que les termes $R_I$, $R_Q$, $K_I$ et $K_Q$ s'annulent dans le cas idéal et qu'ils sont inférieurs à ceux qu'on obtiendrait en sortie du circuit 3 en l'absence du circuit analogique 7. Ceci permet de conclure que les tensions parasites dues aux DC-offset et IMD2 sont réduites avant numérisation des signaux. Cela permet de gagner en dynamique de mesure. Il est important de noter que les démodulateurs IQ classiques à 2 voies RF requièrent des algorithmes d'évaluation des DC-offset et 2 convertisseurs CNA pour leur compensation avant numérisation. Ceci se traduit par une perte d'information résultant du filtrage passe-haut équivalent et une complexité du démodulateur. De plus, la réduction de l'IMD2 dans les démodulateurs IQ classiques à 2 voies nécessite d'ajouter une voie et un traitement numérique supplémentaire.

Résultats de mesures sur un prototype cinq-port en technologie micro-ruban

Signaux utiles et DC-offset

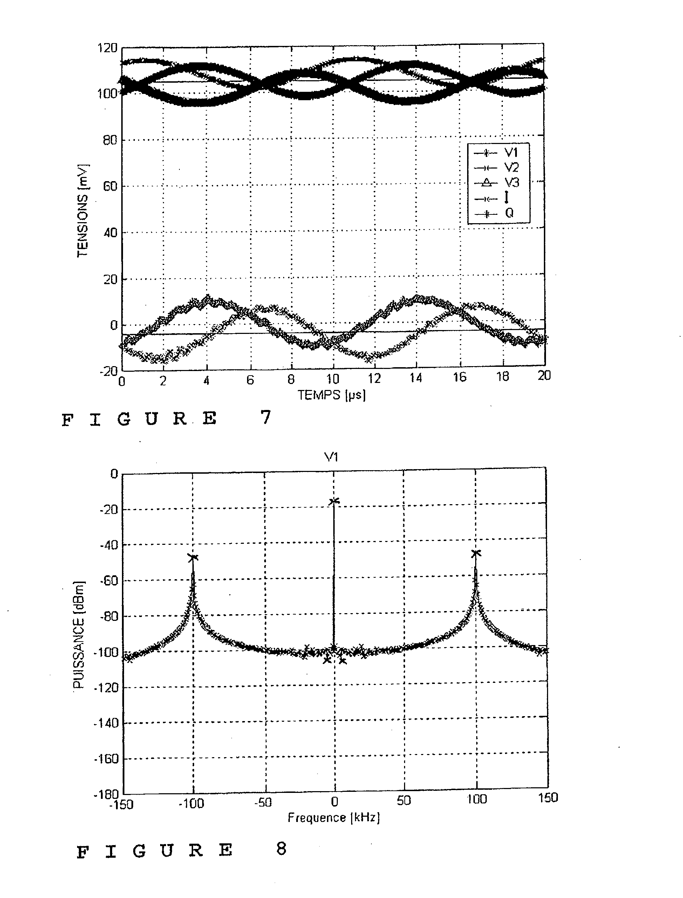

La figure 7 présente les trois tensions V1, V2, V3 des bornes 4, 5, 6 en sortie d'un circuit cinq-port 3 utilisé pour le test du circuit 7 et les deux tensions de sortie 1 et Q du circuit 7.
Les conditions de test et de mesures sont les suivantes.

Le circuit 3 est un cinq-port anneau en technologie micro-ruban. Le circuit 3 fonctionne dans la bande 1,6 GHz à 2,8 GHz.

Au circuit 3 est associé le circuit 7 pour former un démodulateur Zéro-IF complet.

A l'entrée 1 est appliqué un signal RF SSB (Single Side Band : bande latérale unique) de fréquence 1,84001 GHz avec un niveau de puissance globale de -25 dBm.

Les mesures en dB sont exprimées sur une échelle à base 10 car les tensions sont issues de détecteurs quadratiques.

L'entrée 2 est alimentée par une source d'oscillateur local délivrant un signal RF constant de fréquence 1,84 GHz et de niveau de puissance de 0 dBm.

Les tensions mesurées aux bornes de sortie du cinq-port 4, 5 et 6 donnent respectivement des niveaux de DC-offset de 105 mV, 108 mV et 102 mV.

Par contre, ces dernières tensions appliquées au circuit 7 donnent en sortie I (78S) et Q (77S) un niveau respectif de DC-offset de 4,1 mV et 0,12 mV, donc près de 100 mV en moins ou 25 fois plus faible au minimum (14dB en moins) sur la voie I et plus de 800 fois plus faible sur la voie Q, soit 30dB en moins.

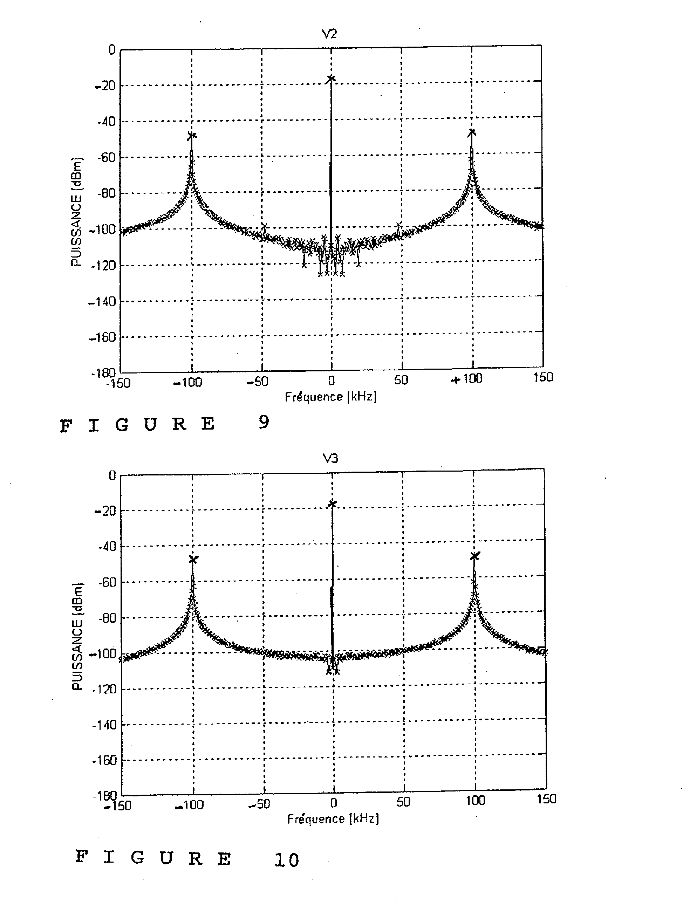

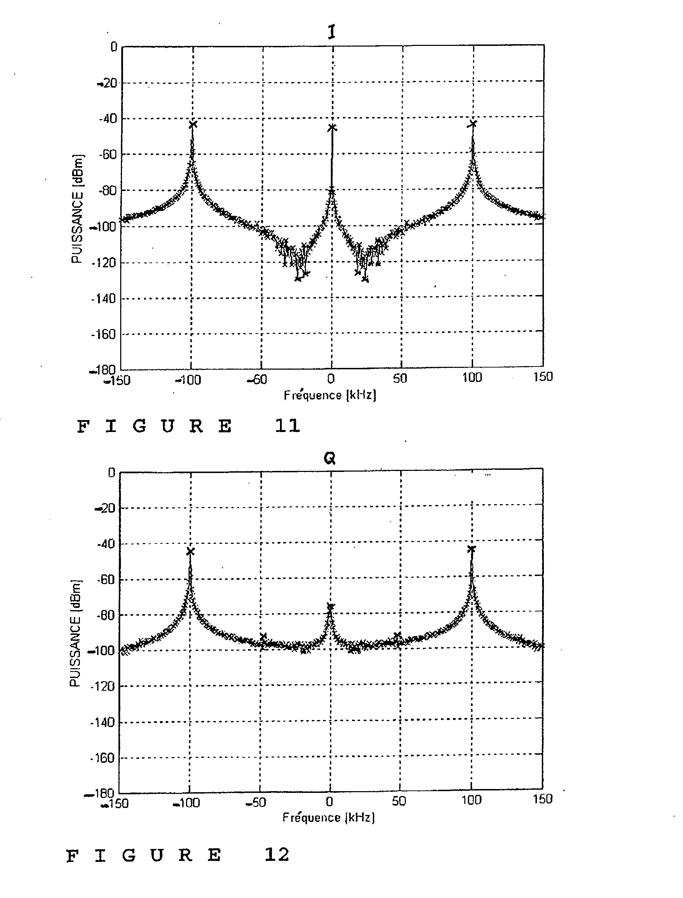

Les figures 8, 9, 10, 11 et 12 représentent respectivement le spectre en puissance des sorties 4, 5, 6, ainsi que I (78S) et Q (77S). Ces spectres affichent la raie du signal utile à $\pm$100 kHz ainsi que la composante de DC-offset à la fréquence nulle. Il est important de noter que le niveau de signal utile est conservé à la sortie du circuit 7 tout en réduisant considérablement le niveau DC-offset. Ce gain de réduction de DC-offset se manifeste directement en gain de dynamique de mesure.

Dynamique de mesure :

Le traitement numérique des signaux dans les récepteurs est essentiel, et, pour cela, deux ou trois convertisseurs analogiques numériques seront utilisés. Le CAN possède des caractéristiques qui en déterminent les dimensions, telles que la fréquence d'échantillonnage (Fe), le nombre de bit (NB), le LSB (bit de poids le plus faible) et la pleine échelle (FS).

Supposant maintenant que l'on vise à démoduler le signal directement depuis les bornes 4, 5 et 6. Il faut, en premier lieu, effectuer une amplification avant conversion numérique. Supposons que la pleine échelle est de FS = $\pm$15 V. Selon la figure 7, la saturation des trois convertisseurs sera atteinte pour une amplification qui amène les tensions de sortie au niveau de pleine échelle FS. Dans ce cas de figure :

Supposant que l'on utilise trois amplificateurs AGC (contrôle automatique de gain) au niveau des bornes 4, 5 et 6, le gain maximal sur chaque amplificateur avant d'atteindre la saturation des CAN sera de :

AGC03 = 21 dB

Par contre, les mêmes AGC placés en sortie du circuit 7 auront pour valeur :

AGC07 = 31 dB

Cela représente un "gain" ou extension de 10dB en dynamique de mesure pour ce cas de figure. Le "gain" aurait été encore plus élevée si la puissance RF à l'entrée 1 avait été au niveau minimal de détection du circuit 3.

Le résidu de DC-offset restant en sortie du circuit 7 est facilement supprimé en numérique.

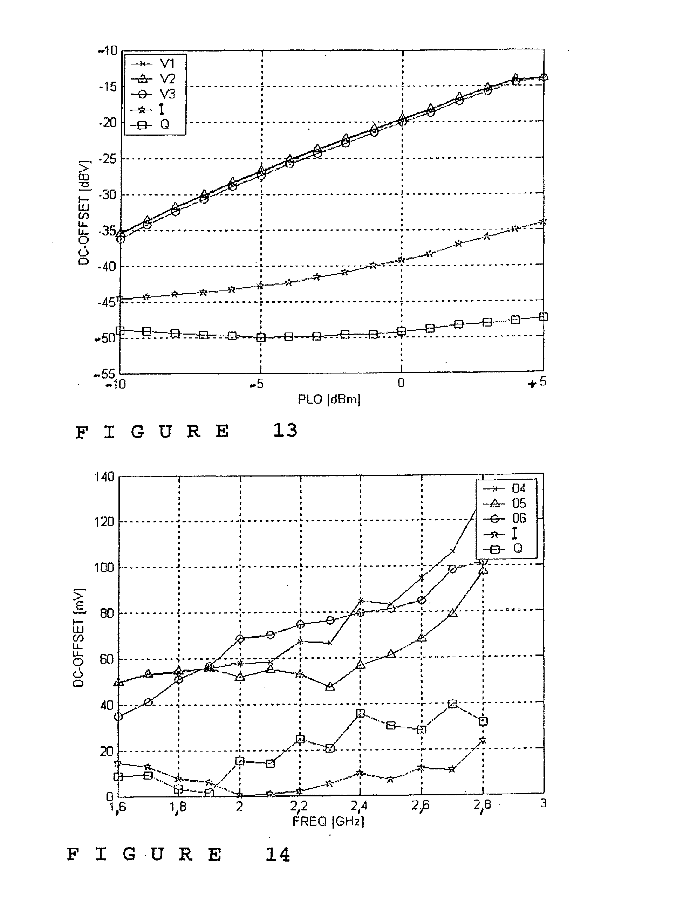

La figure 13 présente l'évolution du DC-offset aux bornes 4, 5 et 6 et aussi au niveau des sorties de I (78S) et Q (77S) en fonction de la puissance de l'oscillateur local LO. Le niveau DC-offset due à l'oscillateur local à la sortie I et Q est nettement plus faible que celui au niveau des bornes 4, 5 et 6. Ceci permet aussi de présenter une technique de lutte contre la fuite de l'oscillateur local LO.

La figure 14 présente l'évolution du DC-offset aux bornes 4, 5 et 6 et aussi au niveau des sorties 1 (78S) et Q (77S) en fonction de la fréquence de l'oscillateur local LO. De même, le niveau de DC-offset aux sorties I et Q reste plus faible et ceci quelle que soit la fréquence de l'oscillateur local LO.

Réduction de l'intermodulation d'ordre 2

La figure 15 présente le produit en bande de base de l'intermodulation d'ordre 2 due aux mélangeurs en fonction de la puissance d'un canal adjacent bi-ton. Comme on peut le constater, le "gain" ou amélioration en réjection obtenu grâce au circuit 7 est d'environ 20 dB. Cela permet, à un démodulateur Zéro-IF à base d'un circuit 3 de type triphasé ou cinq-port utilisant le circuit 7, d'avoir un niveau d'intermodulation d'ordre 2, IIP2, de 20 dB au dessus de celui des mélangeurs 32.

Déphasage des composantes de voie I et Q

Il a été ici démontré théoriquement que la phase entre la voie I et Q reste constante tant que les déphasages entres les voies 4, 5 et 6 était de $\pm\gamma$. La figure 16 valide la théorie en présentant le déphasage analogique entre la voie I et Q avant égalisation. Le déphasage est mesuré en fonction de la fréquence pour différents niveaux de puissance du signal RF à l'entrée 1. La figure 16 montre bien que le déphasage présente une bonne stabilité dans toute la bande allant de 1,6 GHz à 2,8 GHz. En effet, bien que le déphasage entre les voies des bornes 4, 5 et 6 évolue légèrement en fonction de la fréquence, les voies I et Q restent suffisamment déphasées pour garantir une bonne qualité du signal en fonction de la variation de fréquence. Cette technique permet ainsi de réaliser des démodulateurs Zéro-IF très large bande en utilisant uniquement deux voies de sorties.

Qualité de démodulation

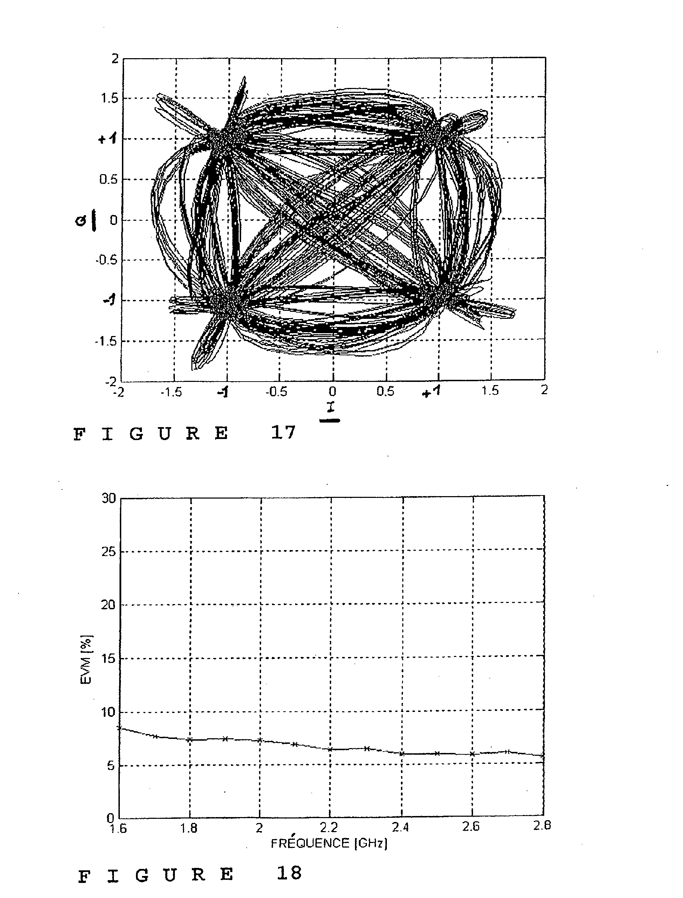

La figure 17, présentant une constellation QPSK démodulée à partir des sorties du circuit 7, permet de confirmer la validité du principe de l'invention. L'égalisation des signaux reçus a bien pris en compte les termes $\mu I$ et $\mu Q$, d'où il résulte que la constellation est parfaitement équilibrée. Les zones autour des quatre points de coordonnées $\pm 1$, $\pm 1$ présentent l'instant de décision et démontrent que la synchronisation symbole s'est bien faite.

L'EVM (Error Vector Magnitude) a été choisie comme figure de mérite pour juger la qualité de démodulation en fonction de la fréquence pour un signal RF de puissance fixe à l'entrée 1. La figure 18 présente le résultat de la mesure de l'EVM effectuée sur la constellation. L'EVM reste de bonne qualité tout au long de la bande 1,6 GHz -2,8 GHz.

Conclusion

Les résultats de mesures démontrent qu'il est possible de démoduler le signal depuis un circuit cinq-port ou triphasé en utilisant le circuit 7.

Le circuit 7 permet :

d'omettre l'étape de calibrage numérique,
d'appliquer de bons coefficients sans faire appel à une unité de calcul,
d'omettre un CAN (deux seulement au lieu de trois),
de réduire le DC-offset sans faire appel à un autre circuit,
de réduire l'IMD2 sans faire appel à un autre circuit,
d'améliorer la dynamique de mesure,
de garantir un déphasage sensiblement constant entre les voies I et Q en fonction de la fréquence,
de garantir une qualité de démodulation sensiblement constante dans toute la bande.

Le circuit 7 ne nécessite pas un réglage des coefficients de pondération.

Le circuit 7 n'impose aucune contrainte sur les signaux aux entrées 1 et 2.

Le circuit 7 ne nécessite aucune manipulation particulière, humaine ou logicielle.

Le circuit 7 est applicable à tout circuit utilisant le principe cinq-port ou triphasé.

Le circuit 7, d'encombrement limité, est ainsi facilement intégrable dans toutes les technologies.

ANNEXE A

A partir des équations (10), (11) et (12), pour des raisons de simplification mathématique, on suppose que les termes en $K_i$ peuvent être estimés en prenant une moyenne des tensions des bornes 4, 5 et 6 et, par la suite, on supprime des tensions $v_i(t)$ et finalement on obtient les expressions suivantes :

$$\widetilde{v}_i(t) = v_i(t) - K_i \qquad\qquad (A\text{-}1)$$

ce qui donne à partir des équations (10),(11) et (12):

$$\widetilde{v}_3(t) = R_3\, n(t) + S_3\, \cos\phi_3\, z_I(t) + S_3\, \sin\phi_3\, z_Q(t) \qquad\qquad (A\text{-}2)$$

$$\tilde{v}_4(t) = R_4 n(t) + S_4 \cos \phi_4 z_I(t) + S_4 \sin \phi_4 z_Q(t) \tag{A-3}$$

$$\tilde{v}_5(t) = R_5 n(t) + S_5 \cos \phi_5 z_I(t) + S_5 \sin \phi_5 z_Q(t) \tag{A-4}$$

Sous forme matricielles ces trois dernières équations s'écrivent :

$$\begin{bmatrix} \tilde{v}_3(t) \\ \tilde{v}_4(t) \\ \tilde{v}_5(t) \end{bmatrix} = \begin{bmatrix} R_3 & S_3 \cos \phi_3 & S_3 \sin \phi_3 \\ R_4 & S_4 \cos \phi_4 & S_4 \sin \phi_4 \\ R_5 & S_5 \cos \phi_5 & S_5 \sin \phi_5 \end{bmatrix} \cdot \begin{bmatrix} n(t) \\ z_I(t) \\ z_Q(t) \end{bmatrix} \tag{A-5}$$

Ayant les tensions $v_i$ nous recherchons $z_I$ et $z_Q$, la relation matricielle est :

$$\begin{bmatrix} n(t) \\ z_I(t) \\ z_Q(t) \end{bmatrix} = \begin{bmatrix} r_n & s_n & t_n \\ r_I & s_I & t_I \\ r_Q & s_Q & t_Q \end{bmatrix} \begin{bmatrix} \tilde{v}_3(t) \\ \tilde{v}_4(t) \\ \tilde{v}_5(t) \end{bmatrix} \cdot \tag{A-6}$$

n(t) étant un signal indésirable, ce qui nous intéresse ce sont les relations :

$$z_I(t) = r_I \tilde{v}_3(t) + s_I \tilde{v}_4(t) + t_I \tilde{v}_5(t) \tag{A-7}$$

$$z_Q(t) = r_Q \tilde{v}_3(t) + s_Q \tilde{v}_4(t) + t_Q \tilde{v}_5(t) \tag{A-8}$$

Sachant que

$$\begin{bmatrix} r_n & s_n & t_n \\ r_I & s_I & t_I \\ r_Q & s_Q & t_Q \end{bmatrix} = inv \begin{bmatrix} R_3 & S_3 \cos \phi_3 & S_3 \sin \phi_3 \\ R_4 & S_4 \cos \phi_4 & S_4 \sin \phi_4 \\ R_5 & S_5 \cos \phi_5 & S_5 \sin \phi_5 \end{bmatrix} \tag{A-9}$$

on en déduit

$$r_Q = \frac{1}{S_3 \chi} \left[ \frac{R_5 S_4}{R_3 S_3} \cos \phi_4 - \frac{R_4 S_5}{R_3 S_3} \cos \phi_5 \right] \tag{A-10}$$

$$s_Q = \frac{1}{S_3 \chi} \left[ \frac{S_5}{S_3} \cos \phi_5 - \frac{R_5}{R_3} \cos \phi_3 \right] \tag{A-11}$$

$$t_Q = \frac{1}{S_3 \chi} \left[ \frac{R_4}{R_3} \cos \phi_3 - \frac{S_4}{S_3} \cos \phi_4 \right] \tag{A-12}$$

$$r_I = \frac{1}{S_3 \chi} \left[ \frac{R_4 S_5}{R_3 S_3} \sin \phi_5 - \frac{R_5 S_4}{R_3 S_3} \sin \phi_4 \right] \tag{A-13}$$

$$s_I = \frac{1}{S_3\chi}\left[\frac{R_5}{R_3}\sin\phi_3 - \frac{S_5}{S_3}\sin\phi_5\right] \qquad (A\text{-}14)$$

$$t_I = \frac{1}{S_3\chi}\left[\frac{S_1}{S_3}\sin\phi_4 - \frac{R_4}{R_3}\sin\phi_3\right] \qquad (A\text{-}15)$$

avec

$$\chi = \frac{R_5 S_4}{R_3 S_3}\sin(\phi_3 - \phi_4) + \frac{R_4 S_5}{R_3 S_3}\sin(\phi_5 - \phi_3) + \frac{S_4 S_5}{S_3^2}\sin(\phi_4 - \phi_5) \qquad (A\text{-}16)$$

Afin de garantir une équipartition de la puissance, la conception du circuit 3 est faite de façon à obtenir une symétrie entre les voies. Ce qui est équivalent à dire en fonction des termes élaborés dans le modèle en figure 2 et figure 3 :

$$A_1 = A_2 = A_3 \quad \text{et} \quad B_1 = B_2 = B_3 \qquad (A\text{-}17)$$

De ces dernières conditions découle la relation suivante :

$$R_1 = R_2 = R_3 \quad \text{et} \quad S_1 = S_2 = S_3 = S \qquad (A\text{-}18)$$

Prenant compte des relations (22)-(30), on écrit :

$$\chi = \sin(\phi_3 - \phi_4) + \sin(\phi_5 - \phi_3) + \sin(\phi_4 - \phi_5) \qquad (A\text{-}19)$$

$$r_I = \frac{1}{S\chi}\left[\sin\phi_5 - \sin\phi_4\right] \qquad (A\text{-}20)$$

$$s_I = \frac{1}{S\chi}\left[\sin\phi_3 - \sin\phi_5\right] \qquad (A\text{-}21)$$

$$t_I = \frac{1}{S\chi}\left[\sin\phi_4 - \sin\phi_3\right] \qquad (A\text{-}22)$$

$$r_Q = \frac{1}{S\chi}\left[\cos\phi_4 - \cos\phi_5\right] \qquad (A\text{-}23)$$

$$s_Q = \frac{1}{S\chi}\left[\cos\phi_5 - \cos\phi_3\right] \qquad (A\text{-}24)$$

$$t_Q = \frac{1}{S\chi}\left[\cos\phi_3 - \cos\phi_4\right] \qquad (A\text{-}25)$$

Dans une utilisation récepteur du circuit 3, « *cinq-port* » ou « *triphasé* », une opération de calibrage consiste à injecter un signal connu à l'entrée 1 et ensuite résoudre le système pour estimer les constantes de calibrage $r_I$, $s_I$, $t_I$, $r_Q$, $s_Q$, et $t_Q$, sauf que, après cette opération, lors de son utilisation dans un système réel où, à l'entrée 1, se situe une antenne réceptrice, l'atténuation et le déphasage apportés par le canal ne sont pas pris en compte par ces constantes, si bien qu'un second calibrage, appelé égalisation, est effectué dans tous les types de démodulateurs. Donc sachant que l'égalisation sera faite par la suite, la correction en amplitude n'est pas nécessaire lors du calibrage du circuit 3 puisqu'elle sera réalisée lors de l'égalisation, mais la relation permettant le passage de l'espace triphasé au biphasé est importante à déterminer. Ainsi, la variable S, dans les équations de (A-20) à (A-25), peut être supprimée de l'étape de calibrage.

Ce qui donne:

$$r_I' = \frac{1}{\chi}\left[\sin\phi_5 - \sin\phi_4\right] \qquad\qquad (A\text{-}26)$$

$$s_I' = \frac{1}{\chi}\left[\sin\phi_3 - \sin\phi_5\right] \qquad\qquad (A\text{-}27)$$

$$t_I' = \frac{1}{\chi}\left[\sin\phi_4 - \sin\phi_3\right] \qquad\qquad (A\text{-}28)$$

$$r_Q' = \frac{1}{\chi}\left[\cos\phi_4 - \cos\phi_5\right] \qquad\qquad (A\text{-}29)$$

$$s_Q' = \frac{1}{\chi}\left[\cos\phi_5 - \cos\phi_3\right] \qquad\qquad (A\text{-}30)$$

$$t_Q' = \frac{1}{\chi}\left[\cos\phi_3 - \cos\phi_4\right] \qquad\qquad (A\text{-}31)$$

Sachant que

$$\sin a - \sin b = 2\sin\left(\frac{a-b}{2}\right)\cos\left(\frac{a+b}{2}\right) \text{ et que } \cos a - \cos b = -2\sin\left(\frac{a-b}{2}\right)\sin\left(\frac{a+b}{2}\right)$$
$$(A\text{-}32)$$

$$r_I' = \frac{2}{\chi}\left[\sin\left(\frac{\phi_5-\phi_4}{2}\right)\cos\left(\frac{\phi_5+\phi_4}{2}\right)\right] \qquad\qquad (A\text{-}33)$$

$$s_I' = \frac{2}{\chi}\left[\sin\left(\frac{\phi_3-\phi_5}{2}\right)\cos\left(\frac{\phi_3+\phi_5}{2}\right)\right] \qquad\qquad (A\text{-}34)$$

$$t_I' = \frac{2}{\chi}\left[\sin\left(\frac{\phi_4-\phi_3}{2}\right)\cos\left(\frac{\phi_4+\phi_3}{2}\right)\right] \qquad\qquad (A\text{-}35)$$

$$r_Q' = \frac{-2}{\chi}\left[\sin\left(\frac{\phi_4-\phi_5}{2}\right)\sin\left(\frac{\phi_4+\phi_5}{2}\right)\right] \qquad\qquad (A\text{-}36)$$

$$s_Q' = \frac{-2}{\chi}\left[sin\left(\frac{\phi_5 - \phi_3}{2}\right)sin\left(\frac{\phi_5 + \phi_3}{2}\right)\right] \qquad (A\text{-}37)$$

$$t_Q' = \frac{-2}{\chi}\left[sin\left(\frac{\phi_3 - \phi_4}{2}\right)sin\left(\frac{\phi_3 + \phi_4}{2}\right)\right] \qquad (A\text{-}38)$$

Supposons maintenant que :

$$\phi_3 = c_0 + \gamma\,,\ \ \phi_4 = c_0\ \ et\ \ \phi_5 = c_0 - \gamma \qquad (A\text{-}39)$$

(31) et (51) donnent

$$\chi = sin(\gamma) \qquad (A\text{-}40)$$

D'après les équations (45)-(50) et (51) on en déduit que :

$$r_I' = \frac{2}{\chi}\left[sin\left(\frac{-\gamma}{2}\right)cos\left(\frac{2C_0 - \gamma}{2}\right)\right] \qquad (A\text{-}41)$$

$$s_I' = \frac{2}{\chi}\left[sin\,\gamma\,cos\left(\frac{2C_0}{2}\right)\right] \qquad (A\text{-}42)$$

$$t_I' = \frac{2}{\chi}\left[sin\left(\frac{-\gamma}{2}\right)cos\left(\frac{2C_0 + \gamma}{2}\right)\right] \qquad (A\text{-}43)$$

$$r_Q' = \frac{-2}{\chi}\left[sin\left(\frac{\gamma}{2}\right)sin\left(\frac{-\gamma + 2C_0}{2}\right)\right] \qquad (A\text{-}44)$$

$$s_Q' = \frac{-2}{\chi}\left[sin(-\gamma)sin\left(\frac{2C_0}{2}\right)\right] \qquad (A\text{-}45)$$

$$t_Q' = \frac{-2}{\chi}\left[sin\left(\frac{\gamma}{2}\right)sin\left(\frac{2C_0 + \gamma}{2}\right)\right] \qquad (A\text{-}46)$$

Sachant que

$$\chi = 2\,sin\left(\gamma\!\!\Big/\!2\right)cos\left(\gamma\!\!\Big/\!2\right) \qquad (A\text{-}47)$$

$$r_I' = \frac{-1}{cos\left(\frac{\gamma}{2}\right)}\left[cos\left(\frac{2C_0 - \gamma}{2}\right)\right] \qquad (A\text{-}48)$$

$$s_I{}' = 2[cos(C_0)] \qquad \text{(A-49)}$$

$$t_I{}' = \frac{-1}{cos\left(\dfrac{\gamma}{2}\right)}\left[cos\left(\frac{2C_0 + \gamma}{2}\right)\right] \qquad \text{(A-50)}$$

$$r_Q{}' = \frac{-1}{cos\left(\dfrac{\gamma}{2}\right)}\left[sin\left(\frac{-\gamma + 2C_0}{2}\right)\right] \qquad \text{(A-51)}$$

$$s_Q{}' = 2[sin\,C_0] \qquad \text{(A-52)}$$

$$t_Q{}' = \frac{-1}{cos\left(\dfrac{\gamma}{2}\right)}\left[sin\left(\frac{2C_0 + \gamma}{2}\right)\right] \qquad \text{(A-53)}$$

Comme on peut le constater, $C_0$ correspond à une rotation de la matrice formée par les constantes $r_I$, $s_I$, $t_I$, $r_Q$, $s_Q$, et $t_Q$, et cela est pris en compte aussi lors de la procédure d'égalisation, de sorte qu'il est justifié de considérer que $C_0 = 0$.

$$r_I{}' = -1 \qquad \text{(A-54)}$$

$$s_I{}' = 2 \qquad \text{(A-55)}$$

$$t_I{}' = -1 \qquad \text{(A-56)}$$

Remarque : ces valeurs sont déterminées quel que soit $\gamma$, le déphasage des signaux de sortie.

$$r_Q{}' = tan\left(\frac{\gamma}{2}\right) \qquad \text{(A-57)}$$

$$s_Q{}' = 0 \qquad \text{(A-58)}$$

$$t_Q{}' = -tan\left(\frac{\gamma}{2}\right) \qquad \text{(A-59)}$$

Remarque : ces valeurs s'expriment toutes linéairement en fonction de $tan\left(\dfrac{\gamma}{2}\right)$.

Étant donné que le terme

$$tan\left(\frac{\gamma}{2}\right)$$

apparaît sur les trois constantes, il sera un facteur pour $z_Q$ (il est pris en compte dans $\mu_Q$ (14) ), et donc on peut aussi l'estimer lors de la procédure d'égalisation, et on obtient finalement l'expression la plus simple et généralisée, quel que soit $\gamma$, des constantes de calibrage.

$$r'_I = -1 \tag{A-60}$$

$$s'_I = 2 \tag{A-61}$$

$$t'_I = -1 \tag{A-62}$$

$$r'_Q = 1 \tag{A-63}$$

$$s'_Q = 0 \tag{A-64}$$

$$t'_Q = -1 \tag{A-65}$$

Et ainsi on écrit :

$$z_I{}'(t) = -v_3(t) + 2v_4(t) - v_5(t) \tag{A-66}$$

$$z_Q{}'(t) = v_3(t) - v_5(t) \tag{A-67}$$

ANNEXE B

Sans aucune supposition d'après ces dernières expressions, les termes perturbateurs tel que le DC-offset ($K_I$ et $K_Q$) et les termes en IMD2 ($R_I$ et $R_Q$) seront éliminés dans le meilleur des cas (symétrie des voies) et, sinon, en cas de dissymétrie des voies, ils seront très faibles. Les mesures présentées aux figures 7 à 15 valident cette affirmation. On obtient une réjection de DC-offset de l'ordre de 30 dB et aussi une rejection de l'IMD2 de l'ordre de 20 dB.

La réduction du DC-offset est l'une des solutions apportées par ce principe, et cela permet d'utiliser des amplificateurs vidéo à la sortie des démodulateurs sans handicaper la dynamique de mesure. La réduction de l'IMD2 est aussi un avantage de cette technique sans faire appel à des algorithmes supplémentaires.

Un autre aspect de l'apport de la présente invention est la réduction, d'une unité, du nombre de convertisseurs CAN. Un autre avantage sur les conditions d'orthogonalité (90°) des voies I et Q apparaît aussi et, pour l'expliquer plus à fond, on effectue quelques opérations mathématiques.

Considérant le signal utile à la sortie du circuit 7, on note :

$$z_I{}'(t) = z_I{}''(t) + N_I \text{ et } z_Q{}'(t) = z_Q{}''(t) + N_Q \tag{B-1}$$

avec

$$z_I{}''(t) = \left[-S_3 \cos\phi_3 + 2S_4 \cos\phi_4 - S_5 \cos\phi_5\right] z_I(t) + \left[-S_3 \sin\phi_3 + 2S_4 \sin\phi_4 - S_5 \sin\phi_5\right] z_Q(t) \tag{B-2}$$

$$z_Q{}''(t) = \left[S_3 \cos\phi_3 - S_5 \cos\phi_5\right] z_I(t) + \left[S_3 \sin\phi_3 - S_5 \sin\phi_5\right] z_Q(t) \tag{B-3}$$

$N_I$ et $N_Q$ sont les signaux indésirables, à supprimer

Sous forme vectorielle, on écrit :

$$\begin{bmatrix} z_I''(t) \\ z_Q''(t) \end{bmatrix} = \begin{bmatrix} \left[-S_3\cos\phi_3 + 2S_4\cos\phi_4 - S_5\cos\phi_5\right] & \left[-S_3\sin\phi_3 + 2S_4\sin\phi_4 - S_5\sin\phi_5\right] \\ \left[S_3\cos\phi_3 - S_5\cos\phi_5\right] & \left[S_3\sin\phi_3 - S_5\sin\phi_5\right] \end{bmatrix} \times \begin{bmatrix} z_I(t) \\ z_Q(t) \end{bmatrix}$$

$$( B\text{-}4)$$

soit autrement,

$$\begin{bmatrix} z_I''(t) \\ z_Q''(t) \end{bmatrix} = \begin{bmatrix} \vec{a}_I \\ \vec{a}_Q \end{bmatrix} \times \begin{bmatrix} z_I(t) \\ z_Q(t) \end{bmatrix} \tag{B-5}$$

$\vec{a}_I$ et $\vec{a}_Q$ étant la base vectorielle reliant les signaux en sortie du circuit cinq-port ou triphasé 3 à la sortie $z_I$ et $z_Q$.

L'orthogonalité entre $z_I$ et $z_Q$ est déterminante pour une bonne qualité de démodulation. L'orthogonalité entre $z_I$ et $z_Q$ va dépendre de l'orthogonalité entre $\vec{a}_I$ et $\vec{a}_Q$.

Le produit vectoriel des deux vecteurs $\vec{a}_I$ et $\vec{a}_Q$ donne :

$$\vec{a}_I \times \vec{a}_Q =$$
$$\left[-S_3\cos\phi_3 + 2S_4\cos\phi_4 - S_5\cos\phi_5\right]\cdot\left[S_3\cos\phi_3 - S_5\cos\phi_5\right] + \left[-S_3\sin\phi_3 + 2S_4\sin\phi_4 - S_5\sin\phi_5\right]\cdot\left[S_3\sin\phi_3 - S_5\sin\phi_5\right]$$
$$(B\text{-}6)$$

$$= 2S_3S_4\cos(\phi_3 - \phi_4) - 2S_5S_4\cos(\phi_5 - \phi_4) \tag{B-7}$$

$\vec{a}_I$ et $\vec{a}_Q$ sont orthogonaux si :

$$\vec{a}_I \times \vec{a}_Q = 0 \tag{B-8}$$

ce qui est équivalent selon (B-7) à :

$$2S_3S_4\cos(\phi_3 - \phi_4) - 2S_5S_4\cos(\phi_5 - \phi_4) = 0 \tag{B-9}$$

De cette dernière expression, on déduit que, pour garantir une orthogonalité des voies I et Q, il suffit de répondre aux conditions de l'équation (B-9) ce qui, techniquement, veut dire qu'il faut que le cinq-port soit symétrique en phase et que la voie i = 3 soit identique à la voie i = 5 en terme de gain. La majorité des architectures cinq-port dans la littérature remplit cette condition et plus particulièrement le cinq-port en anneau est un exemple de cinq-port vérifiant cette condition.

Donc, bien que les phases de la base vectorielle évoluent en fonction de la fréquence $f_c$ à la sortie du démodulateur utilisant le principe selon l'invention, la voie I reste orthogonale à la voie Q tant que l'évolution de phase vérifie la condition :

$$\left|\phi_3(f_c) - \phi_4(f_c)\right| = \left|\phi_5(f_c) - \phi_4(f_c)\right| \tag{B-10}$$

Cela est bien vérifié par les résultats de mesures présentées dans la figure 16.

## Revendications

**1.** Circuit analogique (7) de démodulation de trois composantes mutuellement déphasées d'un signal en bande de base, afin de fournir deux composantes de démodulation en quadrature (I, Q), **caractérisé par le fait qu'**il comporte :

    - trois entrées de circuit (4, 5, 6), prévues pour recevoir respectivement les dites trois composantes,

- des premier et second circuits additionneurs (77, 78), et
- un banc (70) de circuits de pondération (71, 72, 73, 74, 75, 76) reliés, en entrée, aux trois entrées de circuit (4, 5, 6) et reliés, en sortie, à des entrées des premier et second circuits additionneurs (77, 78) pour transmettre à chaque entrée d'additionneur, avec une pondération déterminée, l'une particulière des dites trois composantes, les pondérations étant choisies pour que les premier et second circuits additionneurs (77, 78) fournissent les deux dites composantes de démodulation en quadrature (I, Q) avant numérisation, et en ce que les circuits de pondération présentent chacun un facteur de pondération qui est prédéterminé.

2. Circuit selon la revendication 1, dans lequel au moins l'un des premier et second circuits additionneurs (77, 78) est relié en entrée à trois des circuits de pondération (74, 75, 76).

3. Circuit selon la revendication 2, dans lequel les premier et second circuits additionneurs (77, 78) sont reliés en entrée à trois des circuits de pondération (71, 72, 73 et 74, 75, 76).

4. Circuit selon l'une des revendications 1 à 3, dans lequel le banc (70) comporte six circuits de pondération.

5. Circuit selon l'une des revendications 1 à 4, dans lequel le premier circuit additionneur (77) comporte un premier amplificateur opérationnel (AO1) comportant des première et seconde entrées, respectivement à inversion et directe, respectivement reliées à deux dites entrées de circuit (4, 6) par des premier et cinquième circuits de pondération (71, 75).

6. Circuit selon la revendication 5, dans lequel l'une des dites entrées du premier amplificateur opérationnel (AO1) est en outre reliée à une deuxième (5) des dites entrées de circuit par un troisième circuit de pondération (73).

7. Circuit selon l'une des revendications 1 à 6, dans lequel le second circuit additionneur (78) comporte un second amplificateur opérationnel (AO2) dont une entrée, d'addition, est reliée à deux (4, 6) des entrées de circuit à travers des deuxième et sixième circuits de pondération (72, 76), et un troisième amplificateur opérationnel (AO3) présente une entrée, d'addition, reliée à la deuxième entrée de circuit (5) à travers un quatrième circuit de pondération (74) et en outre reliée à une sortie du deuxième amplificateur opérationnel (AO2) à travers un septième circuit de pondération (79).

8. Circuit selon la revendication 7, dans lequel le quatrième circuit de pondération (74) présente un coefficient de pondération de valeur sensiblement double de celle d'un coefficient de pondération du septième circuit de pondération (79).

9. Démodulateur présentant un étage de sortie comportant un circuit selon l'une des revendications 1 à 8.

10. Procédé de démodulation de trois composantes mutuellement déphasées (SO1, S02, S03) d'un signal analogique en bande de base, afin de fournir deux composantes de démodulation en quadrature (I, Q), **caractérisé par le fait que** :

- recevant les trois composantes (SO1, SO2, SO3) mutuellement déphasées, on effectue une pondération de celles-ci par des facteurs de pondération qui sont prédéterminés, et
- on effectue des première et seconde additions de signaux ainsi pondérés, pour respectivement fournir les deux dites composantes de démodulation en quadrature (I, Q) avant numérisation.

**Patentansprüche**

1. Analoge Schaltung (7) zur Demodulation von drei zueinander phasenverschobenen Komponenten eines Basisbandsignals, um zwei Demodulationskomponenten in Quadratur (I, Q) zu liefern, **dadurch gekennzeichnet, dass** sie Folgendes umfasst:

- drei Schaltungseingänge (4, 5, 6), die vorgesehen sind, um jeweils die drei Komponenten zu empfangen,
- eine erste und eine zweite Additionsschaltung (77, 78) und
- einen Satz (70) von Gewichtungsschaltungen (71, 72, 73, 74, 75, 76), die am Eingang mit den drei Schaltungseingängen (4, 5, 6) verbunden sind und am Ausgang mit Eingängen der ersten und der zweiten Additionsschaltung (77, 78) verbunden sind, um mit einer bestimmten Gewichtung eine bestimmte der drei Komponenten an jeden Addierereingang zu übertragen, wobei die Gewichtungen gewählt sind, damit die erste und die zweite Additionsschaltung (77, 78) die zwei Demodulationskomponenten in Quadratur (I, Q) vor der Digitalisierung liefern, und dadurch, dass die Gewichtungsschaltungen jeweils einen Gewichtungsfaktor aufweisen, der vorbestimmt ist.

2. Schaltung nach Anspruch 1, wobei mindestens eine von der ersten und der zweiten Additionsschaltung (77, 78) am Eingang mit drei der Gewichtungsschaltungen (74, 75, 76) verbunden ist.

3. Schaltung nach Anspruch 2, wobei die erste und die zweite Additionsschaltung (77, 78) am Eingang mit drei der Gewichtungsschaltungen (71, 72, 73 und 74, 75, 76) verbunden sind.

4. Schaltung nach einem der Ansprüche 1 bis 3, wobei der Satz (70) sechs Gewichtungsschaltungen umfasst.

5. Schaltung nach einem der Ansprüche 1 bis 4, wobei die erste Additionsschaltung (77) einen ersten Operationsverstärker (A01) umfasst, der einen ersten und einen zweiten invertierenden beziehungsweise direkten Eingang umfasst, die durch eine erste beziehungsweise fünfte Gewichtungsschaltung (71, 75) mit zwei Schaltungseingängen (4, 6) verbunden sind.

6. Schaltung nach Anspruch 5, wobei der eine der Eingänge des ersten Operationsverstärkers (A01) ferner über eine dritte Gewichtungsschaltung (73) mit einem zweiten (5) der Schaltungseingänge verbunden ist.

7. Schaltung nach einem der Ansprüche 1 bis 6, wobei die zweite Additionsschaltung (78) einen zweiten Operationsverstärker (A02) umfasst, von dem ein Additionseingang über eine zweite und eine sechste Gewichtungsschaltung (72, 76) mit zwei (4, 6) von den Schaltungseingängen verbunden ist, und ein dritter Operationsverstärker (A03) einen Additionseingang aufweist, der über eine vierte Gewichtungsschaltung (74) mit dem zweiten Schaltungseingang (5) verbunden ist und ferner über eine siebte Gewichtungsschaltung (79) mit einem Ausgang des zweiten Operations-verstärkers (A02) verbunden ist.

8. Schaltung nach Anspruch 7, wobei die vierte Gewichtungsschaltung (74) einen Gewichtungs-koeffizienten mit einem Wert aufweist, der im Wesentlichen das Doppelte von demjenigen eines Gewichtungskoeffizienten der siebten Gewichtungs-schaltung (79) beträgt.

9. Demodulator, der eine Ausgangsstufe aufweist, die eine Schaltung nach einem der Ansprüche 1 bis 8 umfasst.

10. Verfahren zur Demodulation von drei zueinander phasenverschobenen Komponenten (SO1, S02, S03) eines analogen Basisbandsignals, um zwei Demodulations-komponenten in Quadratur (I, Q) zu liefern, **dadurch gekennzeichnet, dass**:

- durch den Empfang der drei zueinander phasenverschobenen Komponenten (SO1, S02, S03) eine Gewichtung davon mit Gewichtungsfaktoren durchgeführt wird, die vorbestimmt sind, und
- eine erste und eine zweite Addition von so gewichteten Signalen vorgenommen werden, um jeweils die zwei der Demodulationskomponenten in Quadratur (I, Q) vor der Digitalisierung zu liefern.

**Claims**

1. An analog circuit (7) for demodulating three mutually phase-shifted components of a baseband signal, in order to provide two quadrature demodulation components (I, Q), **characterized in that** it includes:

- three circuit inputs (4, 5, 6), designed to respectively receive said three components,
- first and second adder circuits (77, 78), and
- a bank (70) of weighting circuits (71, 72, 73, 74, 75, 76) linked, at input, to the three circuit inputs (4, 5, 6) and linked, at output, to the inputs of the first and second adder circuits (77, 78) so as to transmit to each adder input, with a determined weighting, a particular one of said three components, the weightings being chosen so that the first and second adder circuits (77, 78) provide said two quadrature demodulation components (I, Q) prior to digitization, and **in that** the weighting circuits each have a weighting factor which is predetermined.

2. The circuit according to claim 1, wherein at least one of the first and second adder circuits (77, 78) is linked at input to three of the weighting circuits (74, 75, 76).

3. The circuit according to claim 2, wherein the first and second adder circuits (77, 78) are linked at input to three of the weighting circuits (71, 72, 73 and 74, 75, 76).

4. The circuit according to one of claims 1 to 3, wherein the bank (70) includes six weighting circuits.

5. The circuit according to one of claims 1 to 4, wherein the first adder circuit (77) includes a first operational amplifier (AO1) including first and second respectively inverting and non-inverting inputs, connected to two said circuit inputs (4, 6) by first and fifth weighting circuits (71, 75), respectively.

6. The circuit according to claim 5, wherein one of said inputs of the first operational amplifier (AO1) is also linked to a second (5) of said circuit inputs by a third weighting circuit (73).

7. The circuit according to one of claims 1 to 6, wherein the second adder circuit (78) includes a second operational amplifier (AO2) whereof an adder input is linked to two of the circuit inputs (4, 6) through second and sixth weighting circuits (72, 76), and a third operational amplifier (AO3) has an adder input linked to the second circuit input (5) through a fourth weighting circuit (74) and also linked to an output of the second operational amplifier (AO2) through a seventh weighting circuit (79).

8. The circuit according to claim 7, wherein the fourth weighting circuit (74) has a weighting coefficient with a value substantial twice that of a weighting coefficient of the seventh weighting circuit (79).

9. A demodulator having an output stage including a circuit according to one of claims 1 to 8.

10. A method for demodulating three mutually phase-shifted components (SO1, SO2, SO3) of an analog baseband signal, so as to provide two quadrature demodulation components (I, Q), **characterized in that**:

   - receiving the three mutually phase-shifted components (SO1, SO2, S03), one performs a weighting thereof using predetermined weighting factors, and
   - first and second additions of signals thus weighted are done, to respectively provide the two said quadrature demodulation components (I, Q) prior to digitization.

F I G U R E    1

F I G U R E    2

F I G U R E 3

F I G U R E 4

**Fig. 5**

F I G U R E    6A

F I G U R E    6B

**Fig. 6C**

F I G U R E 7

F I G U R E 8

F I G U R E     9

F I G U R E     10

F I G U R E    11

F I G U R E    12

F I G U R E 13

F I G U R E 14

F I G U R E    15

F I G U R E    16

F I G U R E    17

F I G U R E    18

## RÉFÉRENCES CITÉES DANS LA DESCRIPTION

**Documents brevets cités dans la description**

- US 2006038534 A
- WO 2008021815 A1

**Littérature non-brevet citée dans la description**

- **YI LIU.** Calibrating an industrial microwave six-port instrument using the artificial neural network technique. *IEEE Transactions on Instrumentation and Measurements,* 1996, vol. 45 (2), 651-655
- **XINPING HUANG ; DAN HINDSON ; MICHEL DE LÉSÉLEUC ; MARIO CARON.** 1/q-channel regeneration in 5-port junction based direct receivers. *IEEE MTT-S International Topical Symposium on technologies for wireless applications,* Février 1999, 169-173
- **MIKE FAULKNER.** DC Offset and IM2 Removal in Direct Conversion Receivers. *IEE Electronics Letters,* Juin 2002, vol. 149 (3), 179-184
- **H. PARK et al.** Unified DC Offset Cancellation and i/Q Regeneration with Carrier Phase Recovery in five port junction based Direct receivers. *Proceedings of the 37th European Microwave Conference,* 01 Octobre 2007, 803-806